# EUROPEAN PATENT APPLICATION

(11) **EP 4 746 656 A1**
(43) Date of publication of application: **20.05.2026**
(21) Application number: 24881278.6
(22) Date of filing: 04.09.2024
(51) Int. Cl.: H10K 59/131, H10K 59/35

(54) **DISPLAY SUBSTRATE AND MANUFACTURING METHOD THEREFOR, AND DISPLAY DEVICE**

(30) Priority: 25.10.2023 CN 202311393797
(71) Applicant: BOE Technology Group Co., Ltd., Beijing 100015 (CN); Hefei BOE Joint Technology Co., Ltd., Hefei, Anhui 230012 (CN); Beijing BOE Technology Development Co., Ltd., Beijing 100176 (CN)
(72) Inventor: LIU, Xiuting, Beijing 100176 (CN); YUAN, Zhidong, Beijing 100176 (CN); LI, Yongqian, Beijing 100176 (CN)
(74) Representative: Durán-Corretjer, S.L.P.
(86) International application number: PCT/CN2024/116749
(87) International publication number: WO 2025/086911

(57) **Abstract**

A display substrate and a manufacturing method therefor, and a display device. The display substrate comprises multiple sub-pixels, at least one sub-pixel comprises a pixel driving circuit and a data signal line connected to the pixel driving circuit, the pixel driving circuit at least comprises a storage capacitor and a first transistor, the storage capacitor at least comprises a first electrode plate and a second electrode plate, and the first transistor is connected to the data signal line. In a direction perpendicular to the display substrate, the display substrate comprises a first conductive layer arranged on a base and a semiconductor layer arranged on the side of the first conductive layer away from the base, the first conductive layer at least comprises data signal lines, and the semiconductor layer at least comprises first active layers of first transistors. In at least one sub-pixel, the first active layer is connected to the data signal line by means of a via hole.

## Description

The present application claims the priority to Chinese Patent Application No. 202311393797.1 filed to the CNIPA on October 25, 2023 and entitled "Display Substrate and Manufacturing Method Therefor, and Display Device", contents of which should be construed as being incorporated into the present application by reference.

### Technical Field

The present disclosure relates to, but is not limited to, the field of display technologies, and in particular to a display substrate and a preparation method therefor, and a display apparatus.

### Background

An Organic Light Emitting Diode (OLED) and a Quantum dot Light Emitting Diode (QLED) are active light emitting display devices and have advantages of self-illumination, a wide viewing angle, a high contrast ratio, low power consumption, an extremely high reaction speed, lightness and thinness, flexibility, and a low cost, etc. With continuous development of display technologies, a display apparatus in which an OLED or a QLED is used as a light emitting device and a Thin Film Transistor (TFT) is used for signal control has become a mainstream product in the field of display at present.

### Summary

The following is a summary of subject matters described herein in detail. This summary is not intended to limit the protection scope of claims.

In one aspect, the present disclosure provides a display substrate including a plurality of repetition units, wherein at least one repetition unit includes a plurality of sub-pixels, and at least one sub-pixel includes a pixel drive circuit and a data signal line connected with the pixel drive circuit, the pixel drive circuit at least includes a storage capacitor and a first transistor, and the storage capacitor at least includes a first electrode plate and a second electrode plate, and an orthographic projection of the first electrode plate on a display substrate plane is at least partially overlapped with an orthographic projection of the second electrode plate on the display substrate plane; in a direction perpendicular to the display substrate, the display substrate includes a first conductive layer disposed on a base substrate and a semiconductor layer disposed at a side of the first conductive layer away from the base substrate; the first conductive layer at least includes the data signal line, and the semiconductor layer at least includes the second electrode plate and a first active layer of the first transistor; in at least one sub-pixel, the first active layer is connected with the data signal line through a via.

In an exemplary implementation mode, in at least one sub-pixel, the first active layer and the second electrode plate are of an interconnected integral structure.

In an exemplary implementation mode, the pixel drive circuit further includes a second transistor, and the second transistor is connected with a first power supply line through a power supply connection line. The first conductive layer further includes the first power supply line, and the semiconductor layer further includes the power supply connection line and a second active layer of the second transistor; in at least one sub-pixel, the second active layer is connected with the power supply connection line, and the power supply connection line is connected with the first power supply line through a via.

In an exemplary implementation mode, in at least one sub-pixel, the second active layer and the power supply connection line are of an interconnected integral structure.

In an exemplary implementation mode, a shape of the first power supply line is a straight line or a polyline extending along a second direction, and a shape of the power supply connection line is a straight line or a polyline extending along a first direction, and the first direction intersects with the second direction; two first power supply lines adjacent in the first direction are connected with a same power supply connection line to form a mesh structure.

In an exemplary implementation mode, a shape of the first power supply line is a straight line or a polyline extending along a second direction, and a shape of the power supply connection line is a straight line or a polyline extending along a first direction, and the first direction intersects with the second direction; two first power supply lines adjacent in the first direction are connected with different power supply connection lines.

In an exemplary implementation mode, the display substrate further includes a second conductive layer disposed at a side of the semiconductor layer away from the base substrate, the second conductive layer at least includes a second gate electrode of the second transistor, and the second gate electrode is connected with the second electrode plate through a gate connection electrode.

In an exemplary implementation mode, the display substrate further includes a third conductive layer disposed at a side of the second conductive layer away from the base substrate, the third conductive layer includes, at least, the gate connection electrode; the gate connection electrode is respectively connected with the second gate electrode and the second electrode plate through a same via, or the gate connection electrode is connected with the second gate electrode through one via and connected with the second electrode plate through another via.

In an exemplary implementation mode, the third conductive layer further includes a first electrode and an active connection electrode, the first electrode and the active connection electrode are of an interconnected integral structure, and the active connection electrode is connected with the second active layer through an active via.

In an exemplary implementation mode, the second active layer is connected with the first electrode plate through a plate-level via, or the second active layer is connected with a transparent connection electrode through a plate-level via, and the transparent connection electrode and the first electrode plate are of an interconnected integral structure.

In an exemplary implementation mode, in at least one sub-pixel, an orthographic projection of the active via on the base substrate is at least partially overlapped with an orthographic projection of the plate-level via on the base substrate.

In an exemplary implementation mode, the pixel drive circuit further includes a third transistor, the third transistor at least includes a third active layer, the first conductive layer further includes a compensation signal line, and the compensation signal line is connected with third active layers of the plurality of sub-pixels in the repetition unit through the semiconductor layer.

In an exemplary implementation mode, the semiconductor layer further includes a compensation connection line, the compensation signal line is connected with the compensation connection line through a via, and the compensation connection line is connected with the third active layers of the plurality of sub-pixels in the repetition unit.

In an exemplary implementation mode, in at least one repetition unit, the compensation connection line and the third active layers of the plurality of sub-pixels are of an interconnected integral structure.

In an exemplary implementation mode, in at least one repetition unit, a shape of the compensation signal line is a straight line or a polyline extending along a second direction, and the compensation signal line is disposed at an intermediate position of the repetition unit in a first direction, and the first direction intersects with the second direction.

In an exemplary implementation mode, in at least one repetition unit, a plurality of sub-pixels at least include a red sub-pixel, a white sub-pixel, a green sub-pixel, and a blue sub-pixel sequentially disposed along the first direction, the red sub-pixel includes a red data signal line, the green sub-pixel includes a green data signal line, the blue sub-pixel includes a blue data signal line, the red data signal line is disposed at one side of the compensation signal line in the first direction, and the green data signal line and the blue data signal line are disposed at the other side of the compensation signal line in the first direction.

In an exemplary implementation mode, in at least one repetition unit, a first gap is disposed between a pixel drive circuit of the red sub-pixel and a pixel drive circuit of the white sub-pixel, a second gap is disposed between a pixel drive circuit of the green sub-pixel and a pixel drive circuit of the blue sub-pixel, the red data signal line is disposed in the first gap, and the green data signal line and the blue data signal line are disposed in the second gap.

In an exemplary implementation mode, the first electrode plate is disposed in the first conductive layer.

In an exemplary implementation mode, the display substrate further includes a transparent conductive layer disposed between the base substrate and the first conductive layer, and the first electrode plate is disposed in the transparent conductive layer.

In another aspect, the present disclosure also provides a display apparatus, and the display apparatus includes the display substrate described above.

In yet another aspect, the present disclosure also provides a preparation method of a display substrate, wherein the display substrate includes a plurality of repetition units, at least one repetition unit includes a plurality of sub-pixels, at least one sub-pixel includes a pixel drive circuit and a data signal line connected with the pixel drive circuit, the pixel drive circuit at least includes a storage capacitor and a first transistor, the storage capacitor at least includes a first electrode plate and a second electrode plate, an orthographic projection of the first electrode plate on a display substrate plane is at least partially overlapped with an orthographic projection of the second electrode plate on the display substrate plane; the preparation method includes: forming a first conductive layer on a base substrate, wherein the first conductive layer at least includes the data signal line; and forming a semiconductor layer on the first conductive layer, wherein the semiconductor layer includes at least the second electrode plate and a first active layer of the first transistor; in at least one sub-pixel, the first active layer is connected with the data signal line through a via.

Other aspects may be comprehended upon reading and understanding drawings and detailed description.

### Brief Description of Drawings

Accompanying drawings are intended to provide a further understanding of technical solutions of the present disclosure and form a part of the specification, and are used to explain the technical solutions of the present disclosure together with embodiments of the present disclosure, but do not form limitations on the technical solutions of the present disclosure. Shapes and sizes of various components in the drawings do not reflect actual scales, but are only intended to schematically illustrate contents of the present disclosure.
FIG. 1 is a schematic diagram of a structure of a display apparatus.
FIG. 2 is a schematic diagram of a planar structure of a display substrate according to an exemplary embodiment of the present disclosure.
FIG. 3 is an equivalent circuit diagram of a pixel drive circuit in a repetition unit according to an exemplary embodiment of the present disclosure.
FIG. 4 is a schematic diagram of a structure of a display substrate according to an exemplary embodiment of the present disclosure.
FIG. 5A is a sectional view taken along an A-A direction in FIG. 4.
FIG. 5B is a sectional view taken along a B-B direction in FIG. 4.
FIG. 6 is a schematic diagram of a display substrate after a pattern of a first conductive layer is formed according to the present disclosure.
FIG. 7 is a schematic diagram of a display substrate after a pattern of a first insulation layer is formed according to the present disclosure.
FIGs. 8A and 8B are schematic diagrams of a display substrate after a pattern of a semiconductor layer is formed according to the present disclosure.
FIGs. 9A and 9B are schematic diagrams of a display substrate after a pattern of a second conductive layer is formed according to the present disclosure.
FIG. 10 is a schematic diagram of a display substrate after patterns of a third insulation layer and a planarization layer are formed according to the present disclosure.
FIGs. 11A and 11B are schematic diagrams of a display substrate after a pattern of a third conductive layer is formed according to the present disclosure.
FIG. 12 is a schematic diagram of a display substrate after a pattern of a pixel definition layer is formed according to the present disclosure.
FIG. 13 is a schematic diagram of a structure of another display substrate according to an exemplary embodiment of the present disclosure.
FIG. 14 is a schematic diagram of another display substrate after patterns of a transparent conductive layer and a first conductive layer are formed according to the present disclosure.
FIG. 15 is a schematic diagram of another display substrate after a pattern of a first insulation layer is formed according to the present disclosure.
FIGs. 16A and 16B are schematic diagrams of another display substrate after a pattern of a semiconductor layer is formed according to the present disclosure.
FIGs. 17A and 17B are schematic diagrams of another display substrate after a pattern of a second conductive layer is formed according to the present disclosure.
FIG. 18 is a schematic diagram of another display substrate after patterns of a third insulation layer and a planarization layer are formed according to the present disclosure.
FIGs. 19A and 19B are schematic diagrams of another display substrate after a pattern of a third conductive layer is formed according to the present disclosure.
FIG. 20 is a schematic diagram of a structure of yet another display substrate according to an exemplary embodiment of the present disclosure.

### Reference numbers are described as follows.

- 10-base substrate ;: 11-first electrode plate; 12-second electrode plate;
- 13-transparent connection: 14-shielding electrode; 21-first power supply line;
- electrode;: 23-compensation signal line; 31-first active layer;
- 22-data signal line;: 34-power supply connection
- 32-second active layer;: 33-third active layer; line;
- 35-compensation connection line;: 40-scan signal line; 41-first gate electrode;
- 42-second gate electrode;: 43-third gate electrode; 50-first electrode;
- 51-eleventh connection: 52-twelfth connection 61-first insulation layer;
- electrode;: electrode;
- 62-second insulation layer;: 63-third insulation layer; 64-planarization layer.

### Detailed Description

To make objectives, technical solutions, and advantages of the present disclosure clearer, the embodiments of the present disclosure will be described in detail below with reference to the accompanying drawings. Implementation modes may be implemented in multiple different forms. Those of ordinary skills in the art may easily understand such a fact that modes and contents may be transformed into various forms without departing from the purpose and scope of the present disclosure. Therefore, the present disclosure should not be explained as being limited to contents recorded in following implementation modes only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagram only, and one mode of the present disclosure is not limited to shapes, numerical values, or the like shown in the drawings.

Ordinal numerals "first", "second", "third" and the like in the specification are set not to form limits in numbers but only to avoid confusion between constituent elements.

In the specification, for convenience, expressions "central", "above", "below", "front", "back", "vertical", "horizontal", "top", "bottom", "inside", "outside" and the like for indicating directional or positional relationships are used to illustrate positional relationships between the constituent elements with reference to the accompanying drawings, not to indicate or imply that an involved apparatus or element must have a specific orientation or be structured and operated in the specific orientation but only to easily describe the present specification and simplify the description, and thus should not be understood as limitations on the present disclosure. The positional relationships between the constituent elements may be changed as appropriate based on a direction according to which each constituent element is described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, it may be a fixed connection, or a detachable connection, or an integral connection; it may be a mechanical connection or an electrical connection; it may be a direct connection, or an indirect connection through a middleware, or internal communication between two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as a "source terminal" and a "drain terminal", are interchangeable in the specification.

In the specification, an "electrical connection" includes a case that constituent elements are connected together through an element with a certain electrical action. The "element with a certain electrical action" is not particularly limited as long as electrical signals between the connected constituent elements may be sent and received. Examples of the "element with a certain electrical action" not only include an electrode and a wiring, but also include a switching element such as a transistor, a resistor, an inductor, a capacitor, other elements with various functions, etc.

In the specification, "parallel" refers to a state in which an angle formed by two straight lines is above -10° and below 10°, and thus may include a state in which the angle is above -5° and below 5°. In addition, "perpendicular" refers to a state in which an angle formed by two straight lines is above 80° and below 100°, and thus may include a state in which the angle is above 85° and below 95°.

In the specification, a "film" and a "layer" are interchangeable. For example, a "conductive layer" may be replaced with a "conductive film" sometimes. Similarly, an "insulation film" may be replaced with an "insulation layer" sometimes.

A triangle, rectangle, trapezoid, pentagon, hexagon, or the like in the specification is not strictly defined, and it may be an approximate triangle, rectangle, trapezoid, pentagon, hexagon, or the like. There may be some small deformations caused by tolerance, and there may be a chamfer, an arc edge, deformation, etc.

In the present disclosure, "about" means that a boundary is not defined so strictly and numerical values within process and measurement error ranges are allowed.

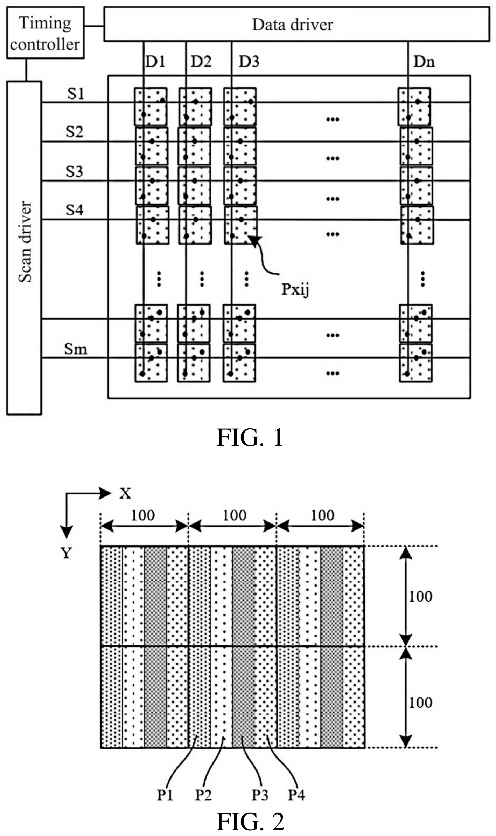

FIG. 1 is a schematic diagram of a structure of a display apparatus. As shown in FIG. 1, an OLED display apparatus may include a timing controller, a data driver, a scan driver, and a pixel array. The timing controller is connected with the data driver and the scan driver respectively, the data driver is connected with a plurality of data signal lines (D1 to Dn) respectively, and the scan driver is connected with a plurality of scan signal lines (S1 to Sm) respectively. The pixel array may include a plurality of sub-pixels Pxij. Each sub-pixel Pxij may be connected to a corresponding data signal line and a corresponding scan signal line, wherein i and j may be natural numbers. At least one sub-pixel Pxij may at least include a circuit unit and a light emitting unit. The circuit unit may at least include a pixel drive circuit connected with a scan signal line and a data signal line respectively. The light emitting unit may at least include a light emitting device connected with the pixel drive circuit of the circuit unit, and the sub-pixel PXij may refer to a sub-pixel in which a pixel drive circuit is connected to an i-th scan signal line and a j-th data signal line. In an exemplary implementation mode, the timing controller may provide a control signal and a grayscale value suitable for a specification of the data driver to the data driver, and may provide a scan start signal, a clock signal or the like suitable for a specification of the scan driver to the scan driver. The data driver may generate a data voltage to be provided to the data signal lines D1, D2, D3, ..., and Dn using the grayscale value and the control signal that are received from the timing controller. For example, the data driver may sample the grayscale value using the clock signal and apply a data voltage corresponding to the grayscale value to the data signal lines D1 to Dn by taking a pixel row as a unit, wherein n may be a natural number. The scan driver may generate a scan signal to be provided to the scan signal lines S1, S2, S3, ..., and Sm by receiving the clock signal, the scan start signal, and the like from the timing controller. For example, the scan driver may sequentially provide a scan signal with an on-level pulse to the scan signal lines S1 to Sm. For example, the scan driver may be constructed in a form of a shift register and generate a scan signal in a manner of sequentially transmitting a scan start signal provided in a form of an on-level pulse to a next-stage circuit under control of the clock signal, wherein m may be a natural number. In an exemplary implementation mode, the pixel array may be disposed on a display substrate.

A display substrate is provided in an exemplary implementation mode of the present disclosure. The display substrate includes a plurality of repetition units, wherein at least one repetition unit includes a plurality of sub-pixels, and at least one sub-pixel includes a pixel drive circuit and a data signal line connected with the pixel drive circuit. The pixel drive circuit at least includes a storage capacitor and a first transistor, and the storage capacitor at least includes a first electrode plate and a second electrode plate, and an orthographic projection of the first electrode plate on a display substrate plane is at least partially overlapped with an orthographic projection of the second electrode plate on the display substrate plane. In a direction perpendicular to the display substrate, the display substrate includes a first conductive layer disposed on a base substrate and a semiconductor layer disposed at a side of the first conductive layer away from the base substrate. The first conductive layer at least includes the data signal line, and the semiconductor layer at least includes the second electrode plate and a first active layer of the first transistor. In at least one sub-pixel, the first active layer is connected with the data signal line through a via.

In an exemplary implementation mode, the pixel drive circuit further includes a second transistor connected with a first power supply line through a power supply connection line. The first conductive layer further includes the first power supply line, and the semiconductor layer further includes the power supply connection line and a second active layer of the second transistor. In at least one sub-pixel, the second active layer is connected with the power supply connection line, and the power supply connection line is connected with the first power supply line through a via.

In an exemplary implementation mode, the pixel drive circuit further includes a third transistor, the third transistor at least includes a third active layer, the first conductive layer further includes a compensation signal line, and the compensation signal line is connected with third active layers of a plurality of sub-pixels in a repetition unit through the semiconductor layer.

In an exemplary implementation mode, the semiconductor layer further includes a compensation connection line, the compensation signal line is connected with the compensation connection line through a via, and the compensation connection line is connected with the third active layers of the plurality of sub-pixels in the repetition unit.

The display substrate of the present disclosure will be illustrated with examples below through some exemplary embodiments.

FIG. 2 is a schematic diagram of a planar structure of a display substrate according to an exemplary embodiment of the present disclosure. As shown in FIG. 2, in an exemplary implementation mode, the display substrate may include a plurality of repetition units 100 in a direction parallel to the display substrate, and at least one repetition unit 100 may include a plurality of sub-pixels sequentially disposed along a first direction X. In an exemplary implementation mode, the repetition units are basic units constituting the display substrate, and the display substrate is constructed by repeating and continuously disposing the repetition units along at least one direction. That is, the display substrate is formed by splicing the plurality of repetition units.

In an exemplary implementation mode, one repetition unit 100 may include four sub-pixels, and the four sub-pixels may include a first sub-pixel P1 that emits light of a first color, a second sub-pixel P2 that emits light of a second color, a third sub-pixel P3 that emits light of a third color, and a fourth sub-pixel P4 that emits light of a fourth color.

In an exemplary implementation mode, in at least one repetition unit 100, the second sub-pixel P2 may be disposed at a side of the first sub-pixel P1 in the first direction X, the third sub-pixel P3 may be disposed at a side of the second sub-pixel P1 in the first direction X, the fourth sub-pixel P4 may be disposed at a side of the third sub-pixel P3 in the first direction X, a plurality of sub-pixels sequentially disposed along the first direction X may be referred to as a pixel row, a plurality of sub-pixels sequentially disposed along a second direction Y may be referred to as a pixel column, a plurality of pixel rows and a plurality of pixel columns constitute a pixel array arranged in an array, and the first direction X intersects with the second direction Y.

In an exemplary implementation mode, the first sub-pixel P1 may be a red sub-pixel (R) emitting red light, the second sub-pixel P2 may be a white sub-pixel (W) emitting white light, the third sub-pixel P3 may be a green sub-pixel (G) emitting green light, and the fourth sub-pixel P4 may be a blue sub-pixel (B) emitting blue light. In some possible implementation modes, an arrangement mode of RWGB may be adjusted according to actual needs, and the present disclosure is not specifically limited thereto.

In an exemplary implementation mode, in a direction perpendicular to the display substrate, the display substrate may at least include a drive circuit layer disposed on the base substrate and a light emitting structure layer disposed at a side of the drive circuit layer away from the base substrate. In at least one repetition unit, the drive circuit layer may include a plurality of circuit units. A circuit unit may at least include a pixel drive circuit, and the pixel drive circuit is connected with a scan signal line, a data signal line, and the like respectively. The pixel drive circuit is configured to receive a data voltage transmitted by the data signal line and output a corresponding current to a light emitting device under control of the scan signal line. The light emitting structure layer may include a plurality of light emitting units, and a light emitting unit may at least include a light emitting device. The light emitting device is connected with a pixel drive circuit of a circuit unit of a sub-pixel in which the light emitting device is located, and the light emitting device is configured to emit light with corresponding brightness in response to a current output by the pixel drive circuit of the sub-pixel in which the light emitting device is located.

In another exemplary implementation mode, in a direction perpendicular to the display substrate, the display substrate may at least include a drive circuit layer disposed on the base substrate, a color film structure layer disposed at a side of the drive circuit layer away from the base substrate, and a light emitting structure layer disposed at a side of the color film structure layer away from the base substrate. In at least one repetition unit, the color film structure layer may include a plurality of color film units. A color film unit may at least include a color filter layer, and the color filter layer is configured to enable a corresponding sub-pixel to emit light of a desired color.

In an exemplary implementation mode, the circuit unit mentioned in the present disclosure refers to a region divided according to a pixel drive circuit. The color film unit mentioned in the present disclosure refers to a region divided according to a color filter layer. The light emitting unit mentioned in the present disclosure refers to a region divided according to a light emitting device. Positions of an orthographic projection of a circuit unit on the base substrate, an orthographic projection of a color filter layer on the base substrate, and an orthographic projection of a light emitting unit on the base substrate may or may not correspond.

In an exemplary embodiment of the present disclosure, positions of an orthographic projection of a circuit unit on the base substrate, an orthographic projection of a color filter layer on the base substrate, and an orthographic projection of a light emitting unit on the base substrate are in one-to-one correspondence. The circuit unit, the color film unit, and the light emitting unit constitute a sub-pixel, therefore, in following contents, a sub-pixel is uniformly used to refer to a circuit unit, a color film unit, and a light emitting unit.

In an exemplary implementation mode, a plurality of sub-pixels sequentially disposed along the first direction X may be referred to as a pixel row, and a plurality of sub-pixels sequentially disposed along the second direction Y may be referred to as a pixel column, and a plurality of pixel rows and a plurality of pixel columns form a pixel array arranged in an array, wherein the first direction X intersects with the second direction Y.

In an exemplary implementation mode, the first direction X may be a horizontal direction, the second direction Y may be a vertical direction, and the first direction X and the second direction Y are perpendicular to each other.

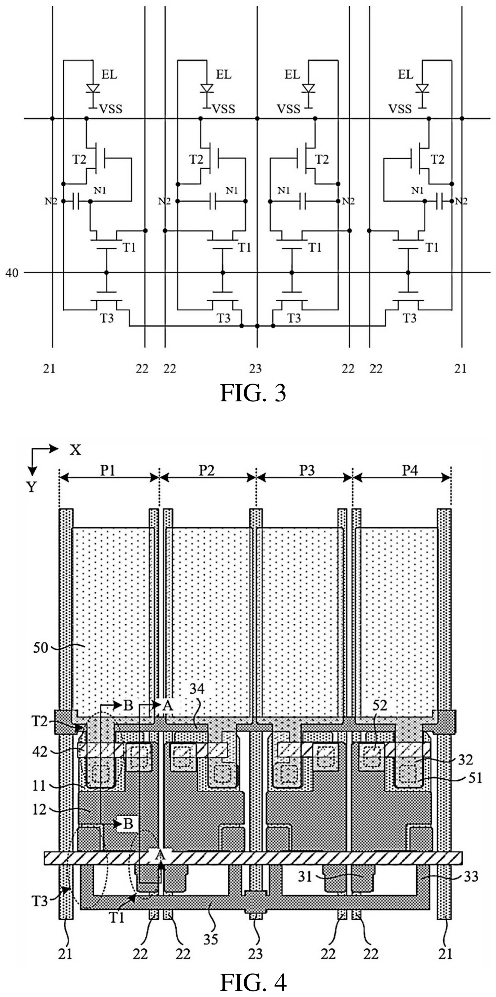

FIG. 3 is an equivalent circuit diagram of a pixel drive circuit in a repetition unit according to an exemplary embodiment of the present disclosure. As shown in FIG. 3, at least one repetition unit may include four pixel drive circuits, the four pixel drive circuits may be arranged in a square manner, and the pixel drive circuits may be of a 3T1C structure.

In an exemplary implementation mode, at least one pixel drive circuit may include three transistors (a first transistor T1, a second transistor T2, and a third transistor T3) and one storage capacitor C. The pixel drive circuit is connected with a scan signal line 40, a first power supply line 21, a data signal line 22, and a compensation signal line 23, respectively.

In an exemplary implementation mode, each pixel drive circuit may include a first node N1 and a second node N2. The first node N1 is connected with a second electrode of the first transistor T1, a gate electrode of the second transistor T2, and a first terminal of the storage capacitor C, respectively, and the second node N2 is connected with a second electrode of the second transistor T2, a second electrode of the third transistor T3, and a second terminal of the storage capacitor C, respectively.

In an exemplary implementation mode, the first terminal of the storage capacitor C is connected with the first node N1, the second terminal of the storage capacitor C is connected with the second node N2, and the storage capacitor C is configured to store a potential of the gate electrode of the second transistor T2.

In an exemplary implementation mode, the first transistor T1 is a switching transistor, the second transistor T2 is a drive transistor, and the third transistor T3 is a compensation transistor.

In an exemplary implementation mode, a gate electrode of the first transistor T1 is connected with the scan signal line 40, a first electrode of the first transistor T1 is connected with the data signal line 22, and a second electrode of the first transistor T1 is connected with the first node N1. When a turned-on signal is applied to the scan signal line 40, the first transistor T1 inputs a data signal of the data signal line 22 to the gate electrode of the second transistor T2.

In an exemplary implementation mode, the gate electrode of the second transistor T2 is connected with the first node N1, a first electrode of the second transistor T2 is connected with the first power supply line 21, and the second electrode of the second transistor T2 is connected with the second node N2. The second transistor T2 generates a corresponding current at the second electrode of the second transistor T2 under control of the data signal received by the gate electrode of the second transistor T2.

In an exemplary implementation mode, a gate electrode of the third transistor T3 is connected with the scan signal line 40, a first electrode of the third transistor T3 is connected with the compensation signal line 23, and a second electrode of the third transistor T3 is connected with the second node N2. When a turned-on signal is applied to the scan signal line 40, the third transistor T3 extracts a threshold voltage Vth and a migration rate of the second transistor T2 in response to a compensation timing, to compensate for the threshold voltage Vth.

In an exemplary implementation mode, in a pixel drive circuit of at least one sub-pixel, a gate electrode of a first transistor T1 and a gate electrode of a third transistor T3 are connected with a same scan signal line 40.

In an exemplary implementation mode, in a plurality of pixel drive circuits of at least one pixel row, gate electrodes of a plurality of first transistors T1 and gate electrodes of a plurality of third transistors T3 are connected with a same scan signal line 40.

In an exemplary implementation mode, in four pixel drive circuits of at least one repetition unit, gate electrodes of four first transistors T1 and gate electrodes of four third transistors T3 are connected with a same scan signal line 40.

In an exemplary implementation mode, a light emitting device EL may be an OLED including a first electrode, an organic emitting layer, and a second electrode which are stacked, or may be a QLED including a first electrode, a quantum dot emitting layer, and a second electrode which are stacked. The first electrode of the light emitting device EL is connected with the second node N2, the second electrode of the light emitting device EL is connected with a second power supply line VSS, and the light emitting device EL emits light with corresponding brightness in response to a current of the second electrode of the second transistor T2. In an exemplary implementation mode, the first electrode may be an anode, and the second electrode may be a cathode; or, the first electrode may be a cathode and the second electrode may be an anode.

In an exemplary implementation mode, a signal of the first power supply line 21 is a high-level signal continuously provided, and a signal of the second power supply line VSS is a low-level signal continuously provided.

In an exemplary implementation mode, the first transistor T1 to the third transistor T3 may be P-type transistors, or may be N-type transistors. Use of a same type of transistors in a pixel drive circuit may simplify a process flow, reduce a process difficulty of a display panel, and improve a product yield. In some possible implementation modes, the first transistor T1 to the third transistor T3 may include a P-type transistor and an N-type transistor.

In an exemplary implementation mode, for the first transistor T1 to the third transistors T3, low temperature poly silicon transistors may be used, oxide transistors may be used, or a low temperature poly silicon transistor and an oxide transistor may be used. An active layer of a low temperature polysilicon transistor is made of Low Temperature Poly Silicon (LTPS), and an active layer of an oxide transistor is made of an oxide semiconductor (Oxide). The low temperature poly silicon transistor has advantages such as a high migration rate and fast charging, and the oxide transistor has advantages such as a low leakage current. The low temperature poly silicon transistor and the oxide transistor are integrated on one display substrate, that is, an LTPS + Oxide (LTPO) display substrate, advantages of both the low temperature poly silicon transistor and the oxide transistor may be utilized, so that low-frequency drive may be achieved, power consumption may be reduced, and display quality may be improved.

FIG. 4 is a schematic diagram of a structure of a display substrate according to an exemplary embodiment of the present disclosure, illustrating a structure of one repetition unit (four sub-pixels) of a bottom emission display substrate. As shown in FIG. 4, in a direction parallel to the display substrate, at least one repetition unit may include a first sub-pixel P1, a second sub-pixel P2, a third sub-pixel P3, and a fourth sub-pixel P4 sequentially arranged along the first direction X, and each sub-pixel includes a pixel drive circuit.

In an exemplary implementation mode, the first sub-pixel P1 may be a red sub-pixel, the second sub-pixel P2 may be a white sub-pixel, the third sub-pixel P3 may be a green sub-pixel, and the fourth sub-pixel P4 may be a blue sub-pixel.

In an exemplary implementation mode, at least one repetition unit may include two first power supply lines 21, four data signal lines 22, one compensation signal line 23, and one scan signal line 40, the above signal lines are all connected with pixel drive circuits in four sub-pixels.

In an exemplary implementation mode, a shape of the scan signal line 40 may be a straight line or a polyline extending along the first direction X. Shapes of the first power supply lines 21, the data signal lines 22, and the compensation signal line 23 may be shapes of straight lines or polylines extending along the second direction Y. The compensation signal line 23 may be disposed in a middle position of the repetition unit in the first direction X, the two first power supply lines 21 may be respectively disposed at two sides of the repetition unit in the first direction X, the four data signal lines 22 and the one compensation signal line 23 may be disposed between the two first power supply lines 21, two of the four data signal lines 22 may be located between the compensation signal line 23 and one of the first power supply lines 21, and the other two of the four data signal lines 22 may be located between the compensation signal line 23 and the other of the first power supply lines 21.

In an exemplary implementation mode, the four data signal lines 22 may at least include a red data signal line located in the red sub-pixel, a green data signal line located in the green sub-pixel, and a blue data signal line located in the blue sub-pixel. The red data signal line may be disposed at one side of the compensation signal line 23 in the first direction X, and the green data signal line and the blue data signal line may be disposed at the other side of the compensation signal line 23 in the first direction X.

In an exemplary implementation mode, a first sub-pixel P1 is formed between one first power supply line 21 and an adjacent data signal line 22 in the first direction X, a second sub-pixel P2 is formed between the compensation signal line 23 and an adjacent data signal line 22 in an opposite direction of the first direction X, a third sub-pixel P3 is formed between the compensation signal line 23 and an adjacent data signal line 22 in the first direction X, and a fourth sub-pixel P4 is formed between the other first power supply line 21 and an adjacent data signal line 22 in the opposite direction of the first direction X.

In an exemplary implementation mode, in at least one repetition unit, a first gap is provided between the pixel drive circuit of the red sub-pixel and the pixel drive circuit of the white sub-pixel, a second gap is provided between the pixel drive circuit of the green sub-pixel and the pixel drive circuit of the blue sub-pixel, the red data signal line is disposed in the first gap, and the green data signal line and the blue data signal line are disposed in the second gap.

In an exemplary implementation mode, among the four sub-pixels of the repetition unit, a pixel drive circuit of at least one sub-pixel may include a first transistor T1, a second transistor T2, a third transistor T3, and a storage capacitor. Each of the first transistor T1, the second transistor T2, and the third transistor T3 may include an active layer, a gate electrode, a first electrode, and a second electrode. The storage capacitor may at least include a first electrode plate 11 and a second electrode plate 12. An orthographic projection of the first electrode plate 11 on a display substrate plane is at least partially overlapped with an orthographic projection of the second electrode plate 12 on the display substrate plane.

In an exemplary implementation mode, in at least one repetition unit, a scan signal line 40 is respectively connected with a gate electrode of a first transistor T1 and a gate electrode of a third transistor T3 in each sub-pixel. A data signal line 22 is connected with a first electrode of a first transistor T1 in each sub-pixel. A compensation signal line 23 is connected with a first electrode of a third transistor T3 in each sub-pixel. A first power supply line 21 is connected with a first electrode of a second transistor T2 in each sub-pixel. A second electrode of a first transistor T1, a gate electrode of a second transistor T2, and a second electrode plate 12 of a storage capacitor in each sub-pixel are connected with each other. A second electrode of a second transistor T2, a second electrode of a third transistor T3, and a first electrode plate 11 of a storage capacitor in each sub-pixel are connected with each other.

In an exemplary implementation mode, at least one repetition unit may further include a power supply connection line 34, and a first power supply line 21 is connected with a first electrode of a second transistor T2 in each sub-pixel through the power supply connection line 34. A shape of the power supply connection line 34 may be a straight line or a polyline extending along the first direction X, and the power supply connection line 34 is connected with two first power supply lines 21 adjacent in the first direction X, so that the power supply connection line 34 extending along the first direction X and the first power supply lines 21 extending along the second direction Y form a mesh structure in the repetition unit.

In an exemplary implementation mode, the power supply connection line 34 may be straddled and disposed in the first sub-pixel P1 to the fourth sub-pixel P4, a first end of the power supply connection line 34 is connected with a first power supply line 21 located in the first sub-pixel P1, a second end of the power supply connection line 34 is connected with a first power supply line 21 in the fourth sub-pixel P4, and a region between the first end and the second end is respectively connected with first electrodes of second transistors T2 in the four sub-pixels. In this way, one first power supply line 21 can supply power signals to the pixel drive circuits of the four sub-pixels through one power supply connection line 34, forming a two-drag-four structure of a first power supply line.

In an exemplary implementation mode, at least one repetition unit may further include a compensation connection line 35, and the compensation signal line 23 is connected with a first electrode of a third transistor T3 in each sub-pixel through the compensation connection line 35. A shape of the compensation connection line 35 may be a straight line or a polyline extending along the first direction X. The compensation connection line 35 is connected with the compensation signal line 23 on one hand and connected with first electrodes of third transistors T3 in the four sub-pixels, respectively on the other hand.

In an exemplary implementation mode, the compensation connection line 35 may be straddled and disposed in the first sub-pixel P1 to the fourth sub-pixel P4. A middle portion of the compensation connection line 35 in the first direction X is connected with the compensation signal line 23. Two sides of the compensation connection line 35 in the first direction X are respectively connected with the first electrodes of the third transistors T3 in the four sub-pixels. In this way, one compensation signal line 23 can supply compensation signals to the pixel drive circuits of the four sub-pixels, forming a one-drag-four structure of a compensation signal line.

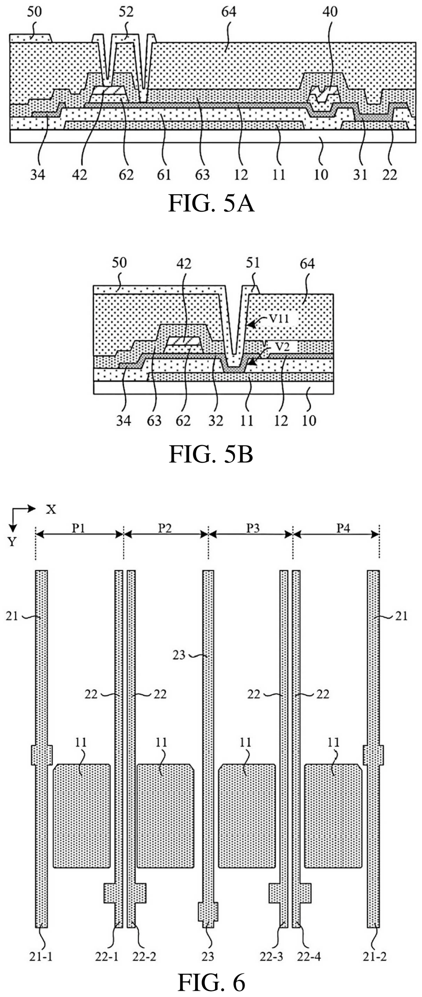

FIG. 5A is a sectional view taken along an A-A direction in FIG. 4, and FIG. 5B is a sectional view taken along a B-B direction in FIG. 4. As shown in FIGs. 4, 5A, and 5B, in a direction perpendicular to the display substrate, the display substrate may at least include a drive circuit layer disposed on a base substrate 10, and a light emitting structure layer disposed at one side of the drive circuit layer away from the base substrate. In an exemplary implementation mode, the drive circuit layer may include a first conductive layer disposed on the base substrate 10, a first insulation layer 61 disposed at a side of the first conductive layer away from the base substrate, a semiconductor layer disposed at a side of the first insulation layer 61 away from the base substrate, a second insulation layer 62 disposed at a side of the semiconductor layer away from the base substrate, a second conductive layer disposed at a side of the second insulation layer 62 away from the base substrate, and a third insulation layer 63 and a planarization layer 64 disposed at a side of the second conductive layer away from the base substrate. The light emitting structure layer may at least include a third conductive layer disposed at a side of the drive circuit layer away from the base substrate.

In an exemplary implementation mode, the first conductive layer may include, at least, the first electrode plate 11 and the data signal line 22, and the semiconductor layer may include at least the second electrode plate 12 and a first active layer 31 of the first transistor T1. In at least one sub-pixel, a first region of a first active layer 31 is connected with the data signal line 22 through a via.

In an exemplary implementation mode, in at least one sub-pixel, a first active layer 31 and a second electrode plate 12 may be of an interconnected integral structure.

In an exemplary implementation mode, the first conductive layer may further include the first power supply line 21, and the semiconductor layer may further include the power supply connection line 34 and a second active layer 32 of the second transistor T2. In at least one sub-pixel, a first region of a second active layer 32 is connected with the power supply connection line 34, and the power supply connection line 34 is connected with the first power supply line 21 through a via.

In an exemplary implementation mode, in at least one sub-pixel, the second active layer 32 and the power supply connection line 34 may be of an interconnected integral structure.

In an exemplary implementation mode, the first conductive layer may further include the compensation connection line 35, the semiconductor layer may further include a third active layer 33 of the third transistor T3, and the compensation signal line 35 is connected with third active layers 33 of a plurality of sub-pixels in the repetition unit through the semiconductor layer.

In an exemplary implementation mode, the semiconductor layer may further include the compensation connection line 35. In at least one repetition unit, the compensation connection line 35 is connected with first regions of third active layer 33 of a plurality of sub-pixels in the repetition unit on one hand, and is connected with the compensation signal line 23 through a via on the other hand.

In an exemplary implementation mode, in at least one repetition unit, the compensation connection line 35 and third active layers 33 of a plurality of sub-pixels may be of an interconnected integral structure.

In an exemplary implementation mode, the second conductive layer may at least include a second gate electrode 42 of the second transistor, the second gate electrode 42 is connected with the second electrode plate 12 through a twelfth connection electrode 52, and the twelfth connection electrode 52 may serve as a gate connection electrode of the present disclosure.

In an exemplary implementation mode, the third conductive layer may at least include a twelfth connection electrode 52. In an implementation mode, the twelfth connection electrode 52 may be connected with the second gate electrode 42 located in the second conductive layer through one via, and connected with the second electrode plate 12 located in the semiconductor layer through another via. In another implementation mode, the twelfth connection electrode 52 may be connected with the second gate electrode 42 located in the second conductive layer and the second electrode plate 12 located in the semiconductor layer, respectively, through a same via.

In an exemplary implementation mode, the third conductive layer may further include a first electrode 50 and an eleventh connection electrode 51, the first electrode 50 and the eleventh connection electrode 51 may be of an interconnected integral structure. The eleventh connection electrode 51 is connected with a second region of the second active layer 32 through an eleventh via V11. The eleventh connection electrode 51 may serve as an active connection electrode of the present disclosure, and the eleventh via V11 may serve as an active via of the present disclosure.

In an exemplary implementation mode, the second region of the second active layer 32 is connected with the first electrode plate 11 through a second via V2, and the second via V2 may serve as a plate-level via of the present disclosure.

In an exemplary implementation mode, in at least one sub-pixel, an orthographic projection of the eleventh via V11 (active via) on the base substrate is at least partially overlapped with an orthographic projection of the second via V2 (plate-level via) on the base substrate.

In an exemplary implementation mode, an area of the orthographic projection of the eleventh via V11 on the base substrate may be larger than an area of the orthographic projection of the second via V2 on the base substrate, which may improve connection reliability.

In an exemplary implementation mode, the first electrode may be an anode of the light emitting structure layer, or the first electrode may be a cathode of the light emitting structure layer.

Exemplary description is made below through a preparation process of a display substrate. A "patterning process" mentioned in the present disclosure includes treatments such as deposition of a film layer, photoresist coating on a film layer, mask exposure, development, etching, and photoresist stripping for a metal material, an inorganic material, or a transparent conductive material, and includes treatments such as organic material coating, mask exposure, and development for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in an entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" after the patterning process. "A and B are disposed in a same layer" in the present disclosure means that A and B are formed simultaneously through a same patterning process, and a "thickness" of a film layer is a dimension of the film layer in a direction perpendicular to a display substrate. In an exemplary implementation mode of the present disclosure, "an orthographic projection of B is within a range of an orthographic projection of A" or "an orthographic projection of A contains an orthographic projection of B" refers to that a boundary of the orthographic projection of B falls within a range of a boundary of the orthographic projection of A, or the boundary of the orthographic projection of A is overlapped with the boundary of the orthographic projection of B.

In an exemplary implementation mode, taking one repetition unit including four sub-pixels (a first sub-pixel P1, a second sub-pixel P2, a third sub-pixel P3, and a fourth sub-pixel P4) as an example, a preparation process of a display substrate in the exemplary implementation mode may include following operations.

(11) A pattern of a first conductive layer is formed. In an exemplary implementation mode, forming the pattern of the first conductive layer may include: depositing a first conductive thin film on a base substrate, patterning the first conductive thin film through a patterning process, and forming a pattern of a first conductive layer on the base substrate, as shown in FIG. 6. In an exemplary implementation mode, the first conductive layer may be referred to as a Shield metal (SHL) layer.

In an exemplary implementation mode, a pattern of a first conductive layer in each sub-pixel in a repetition unit may at least include a first electrode plate 11 of a storage capacitor.

In an exemplary implementation mode, a shape of the first electrode plate 11 may be a rectangle, corners of the rectangle may be chamfered, edges of the rectangle may be polylines, the first electrode plate 11 may be disposed in a middle region of the sub-pixel in a second direction Y, the first electrode plate 11 may be one electrode plate of the storage capacitor, and the first electrode plate 11 is configured to form the storage capacitor with a second electrode plate formed subsequently.

In an exemplary implementation mode, an area of a first electrode plate 11 in each sub-pixel in the repetition unit may be substantially the same, so that a capacity of a storage capacitor in each sub-pixel is substantially the same.

In an exemplary implementation mode, the first conductive layer of the repetition unit may further include two first power supply lines 21, four data signal lines 22, and one compensation signal line 23.

In an exemplary implementation mode, a shape of each of the first power supply lines 21, the data signal lines 22, and the compensation signal line 23 may be a straight line or a polyline of which a main body portion extends along the second direction Y. The compensation signal line 23 may be located in a middle portion of the repetition unit in the first direction X, and may be disposed between the second sub-pixel P2 and the third sub-pixel P3. Two first power supply lines 21 may be located at two sides of the compensation signal line 23 in the first direction X, and may be disposed in the first sub-pixel P1 and the fourth sub-pixel P4, respectively. Four data signal lines 22 may be disposed in each sub-pixel, respectively. Two of the four data signal lines 22 may be located between one first power supply line 21 and the compensation signal line 23, and the other two of the four data signal lines 22 may be located between the other first power supply line 21 and the compensation signal line 23.

In an exemplary implementation mode, the two first power supply lines 21 may include a first first power supply line 21-1 and a second first power supply line 21-2 sequentially disposed along the first direction X, and the four data signal lines 22 may include a first data signal line 22-1, a third data signal line 22-3, and a fourth data signal line 22-4 sequentially disposed along the first direction X. The first first power supply line 21-1 and the first data signal line 22-1 may define a first pixel column, the second data signal line 22-2 and the compensation signal line 23 may define a second pixel column, the compensation signal line 23 and the third data signal line 22-3 may define a third pixel column, and the fourth data signal line 22-4 and the second first power supply line 21-2 may define a fourth pixel column.

In an exemplary implementation mode, the first power supply lines 21, the data signal lines 22, and the compensation signal line 23 may be polygonal lines with non-equal widths. Polygonal lines with variable widths are adopted, which may not only facilitate a layout of a pixel structure, but also reduce a parasitic capacitance.

In an exemplary implementation mode, an orthographic projection of the compensation signal line 23 on the base substrate is at least partially overlapped with an orthographic projection of a vertical reference line on the base substrate. Positions and shapes of the two first power supply lines 21 may be substantially mirror-symmetric with respect to the vertical reference line. Positions and shapes of two data signal lines 22 located at a side of the compensation signal line 23 in an opposite direction of the first direction X and positions and shapes of two data signal lines 22 located at a side of the compensation signal line 23 in the first direction X may be substantially mirror-symmetric with respect to the vertical reference line. Positions and shapes of four first electrode plates 11 in the repetition unit may be substantially mirror-symmetric with respect to the vertical reference line, and the vertical reference line may be a straight line extending along the second direction X and bisecting the repetition unit in the first direction X.

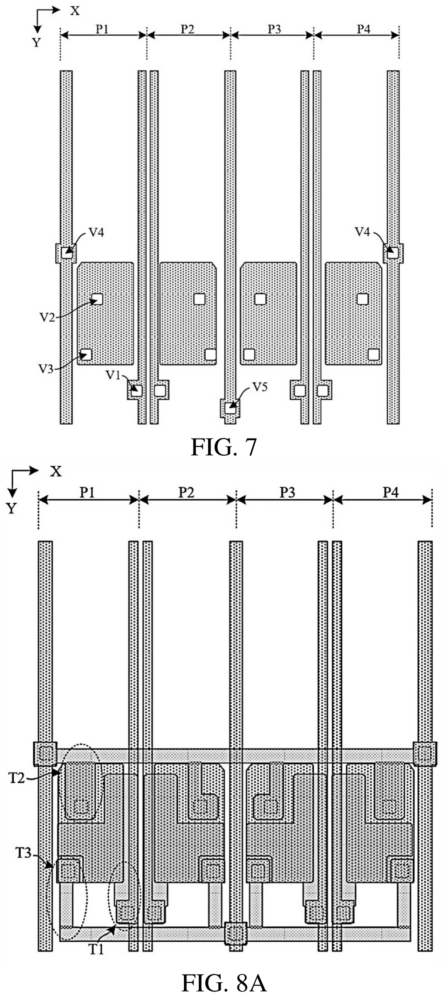

(12) A pattern of a first insulation layer is formed. In an exemplary implementation mode, forming the pattern of the first insulation layer may include: depositing a first insulation thin film on the base substrate on which the aforementioned pattern is formed, patterning the first insulation thin film through a patterning process to form the pattern of the first insulation layer that covers the first insulation layer, wherein a plurality of vias are disposed on the first insulation layer, as shown in FIG. 7.

In an exemplary implementation mode, a plurality of vias of each sub-pixel in the repetition unit at least includes a first via V1, a second via V2, and a third via V3.

In an exemplary implementation mode, an orthographic projection of the first via V1 on the base substrate is at least partially overlapped with an orthographic projection of a data signal line 22 on the base substrate, the first insulation layer within the first via V1 is etched away to expose a surface of the data signal line 22, and the first via V1 is configured such that a first region of a first active layer formed subsequently is connected with the data signal line 22 through the via. In an exemplary implementation mode, the second via V2 may serve as a plate-level via of the present disclosure.

In an exemplary implementation mode, an orthographic projection of the second via V2 on the base substrate and an orthographic projection the third via V3 on the base substrate are at least partially overlapped with an orthographic projection of the first electrode plate 11 on the base substrate. The first insulation layer within the second via V2 and the third via V3 is etched away, exposing a surface of the first electrode plate 11. The second via V2 is configured such that a second region of a second active layer formed subsequently is connected with the first electrode plate 11 through the via, and the third via V3 is configured such that a second region of a third active layer formed subsequently is connected with the first electrode plate 11 through the via.

In an exemplary implementation mode, the first insulation layer in the repetition unit may further include a fourth via V4 and a fifth via V5.

In an exemplary implementation mode, an orthographic projection of the fourth via V4 on the base substrate is at least partially overlapped with an orthographic projection of a first power supply line 21 on the base substrate. The first insulation layer within the fourth via V4 is etched away to expose a surface of the first power supply line 21, and the fourth via V4 is configured such that a power supply connection line formed subsequently is connected with the first power supply line 21 through this via. In an exemplary implementation mode, the fourth via V4 may be disposed in the first sub-pixel P1 and the fourth sub-pixel P4, respectively.

In an exemplary implementation mode, an orthographic projection of the fifth via V5 on the base substrate is at least partially overlapped with an orthographic projection of the compensation signal line 23 on the base substrate. The first insulation layer within the fifth via V5 is etched away to expose a surface of the compensation signal line 23, and the fifth via V5 is configured such that a compensation connection line formed subsequently is connected with the compensation signal line 23 through this via. In an exemplary implementation mode, the fifth via V5 may be disposed between the second sub-pixel P2 and the third sub-pixel P3.

In an exemplary implementation mode, a plurality of vias on the first insulation layer within the repetition unit may be substantially mirror-symmetric with respect to the vertical reference line.

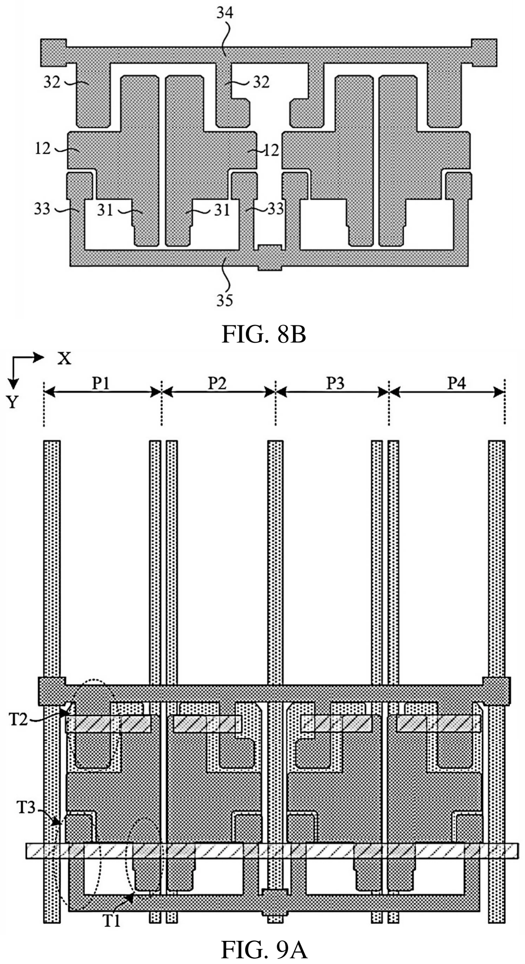

(13) A pattern of a semiconductor layer is formed. In an exemplary implementation mode, forming the pattern of the semiconductor layer may include: depositing a semiconductor thin film on the base substrate on which the aforementioned patterns are formed, and patterning the semiconductor thin film through a patterning process to form the pattern of the semiconductor layer disposed on the first insulation layer, as shown in FIGs. 8A and 8B, wherein FIG. 8B is a schematic plan view of the semiconductor layer in FIG. 8A.

In an exemplary implementation mode, a pattern of a semiconductor layer in each sub-pixel in the repetition unit may at least include a first active layer 31, a second active layer 32, a third active layer 33, a power supply connection line 34, a compensation connection line 35, and a second electrode plate 12.

In an exemplary implementation mode, a shape of the second electrode plate 12 may be a rectangle. An orthographic projection of the second electrode plate 12 on the base substrate is at least partially overlapped with the orthographic projection of the first electrode plate 11 on the base substrate. The second electrode plate 12 is configured to form another electrode plate of the storage capacitor. The first electrode plate 11 and the second electrode plate 12 constitute the storage capacitor of a pixel drive circuit.

In an exemplary implementation mode, in one repetition unit, overlapping areas of orthographic projections of the second electrode plates 12 on the base substrate and orthographic projections of the first electrode plates 11 on the base substrate in sub-pixels may be substantially the same, so that capacities of storage capacitors in the sub-pixels are substantially the same.

In an exemplary implementation mode, a shape of the power supply connection line 34 may be a straight line or a polyline of which a main body portion extends along the first direction X. The power supply connection line 34 may be disposed at a side of the second electrode plate 12 in an opposite direction of the second direction Y, and the power supply connection line 34 is connected with the first power supply line 21 through the fourth via V4.

In an exemplary implementation mode, in one repetition unit, an orthographic projection of a power supply connection line 34 on the base substrate is at least partially overlapped with orthographic projections of four data signal lines 22 on the base substrate, and the orthographic projection of the power supply connection line 34 on the base substrate is at least partially overlapped with an orthographic projection of a compensation signal line 23 on the base substrate.

In an exemplary implementation mode, the power supply connection line 34 may serve as a transverse connection line. The power supply connection line 34 may be connected with each of two first power supply lines 21 in one repetition unit, so that the power supply connection line 34 extending along the first direction X and the first power supply lines 21 extending along the second direction Y form a mesh structure for transmitting a first power supply signal on the display substrate, which not only may effectively reduce a resistance of a first power supply line and reduce a voltage drop of the first power supply signal, but also may effectively improve uniformity of the first power supply signal in the display substrate, effectively improve display uniformity, and improve display quality.

In an exemplary implementation mode, a shape of the compensation connection line 35 may be a straight line or a polyline of which a main body portion extends along the first direction X. The compensation connection line 35 may be disposed at one side of the second electrode plate 12 in the second direction Y, and the compensation connection line 35 is connected with the compensation signal line 23 through the fifth via V5.

In an exemplary implementation mode, in one repetition unit, an orthographic projection of a compensation connection line 35 on the base substrate is at least partially overlapped with orthographic projections of four data signal lines 22 on the base substrate, and the orthographic projection of the compensation connection line 35 on the base substrate is not overlapped with an orthographic projection of a first power supply line 21 on the base substrate.

In an exemplary implementation mode, the first active layer 31 may serve as an active layer of the first transistor T1, the second active layer 32 may serve as an active layer of the second transistor T2, and the third active layer 33 may serve as an active layer of the third transistor T3. The first active layer 31 and the third active layer 33 may be disposed between the compensation connection line 35 and the second electrode plate 12, and the second active layer 32 may be disposed between the power supply connection line 34 and the second electrode plate 12.

In an exemplary implementation mode, each of the first active layer 31, the second active layer 32, and the third active layer 33 may include a channel region, and a first region and a second region located at two sides of the channel region.

In an exemplary implementation mode, a shape of the first active layer 31 may be a strip extending along the second direction Y, and may be disposed at one side of the second electrode plate 12 in the second direction Y. A first region of the first active layer 31 is connected with a data signal line 22 through the first via V1, and a second region of the first active layer 31 is connected with the second electrode plate 12, thereby achieving that a data signal is written to a first electrode of the first transistor T1 by the data signal line 22. In an exemplary implementation mode, a first region of a first active layer 31 in each sub-pixel may be connected with a data signal line 22 through a first via V1, thereby achieving that data signals are written into first electrodes of four first transistors T1 in one repetition unit by four data signal lines.

In an exemplary implementation mode, the four data signal lines 22 may include a first data signal line, a second data signal line, a third data signal line, and a fourth data signal line sequentially disposed along the first direction X. The first data signal line may be located at a side of the first pixel column in the first direction X, and may be connected with a first region of a first active layer in the first sub-pixel P1. The second data signal line may be located at a side of the second pixel column in an opposite direction of the first direction X, and located at a side of the first data signal line in the first direction X, and may be connected with a first region of a first active layer in the second sub-pixel P2. The third data signal line may be located at a side of the third pixel column in the first direction X, and may be connected with a first region of a first active layer in the third sub-pixel P3. The fourth data signal line may be located at a side of the fourth pixel column in the opposite direction of the first direction X, and located at a side of the third data signal line in the first direction X, and may be connected with a first region of a first active layer in the fourth sub-pixel P4.

In an exemplary implementation mode, in one sub-pixel, a first active layer 31 and a second electrode plate 12 may be of an interconnected integral structure.

In an exemplary implementation mode, a shape of the second active layer 32 may be a strip extending along the second direction Y, and an orthographic projection of the second active layer 32 on the base substrate is at least partially overlapped with an orthographic projection of the first electrode plate 11 on the base substrate. An orthographic projection of a channel region of the second active layer 32 on the base substrate may be within a range of the orthographic projection of the first electrode plate 11 on the base substrate, and the first electrode plate 11 may shield the channel region of the second active layer 32 to avoid an influence of light on a channel and reduce a leakage current, thereby avoiding an influence of illumination on characteristics of a transistor, and ensuring electrical performance of the second transistor T2.

In an exemplary implementation mode, the first region of the second active layer 32 is connected with the power supply connection line 34, and the second region of the second active layer 32 is connected with the first electrode plate 11 through the second via V2. Since the power supply connection line 34 is connected with a first power supply line, it is achieved that a first power supply signal is written to a first electrode of the second transistor T2 by a first power supply line 21, and it is also achieved that a second electrode of the second transistor T2 has a same potential as the first electrode plate 11.

In an exemplary implementation mode, two first power supply lines 21 may include a first first power supply line and a second first power supply line, wherein the first first power supply line may be located at a side of the first pixel column in the opposite direction of the first direction X, and the second first power supply line may be located at a side of the fourth pixel column in the first direction X. Since the first first power supply line of the first pixel column may simultaneously supply a first power supply signal to pixel drive circuits in the first sub-pixel P1 to the fourth sub-pixel P4 through the power supply connection line 34, and the second first power supply line of the fourth pixel column may simultaneously supply a first power supply signal to pixel drive circuits in the first sub-pixel P1 to the fourth sub-pixel P4, a first power supply line 21 in one repetition unit has a two-drag-four structure. In the display substrate according to the present disclosure, a first power supply line is designed to have a two-drag-four structure, which saves a quantity of signal lines, reduces occupied space, has a simple structure and a reasonable layout, makes full use of layout space, improves a space utilization rate, and is beneficial to improving a resolution.

In an exemplary implementation mode, two first power supply lines 21 in one repetition unit are substantially mirror-symmetric with respect to a vertical reference line, and four second transistors T2 in one repetition unit are substantially mirror-symmetric with respect to the vertical reference line. This symmetrical structure of the present disclosure may ensure that voltage drops of the first power supply lines written into the second transistors T2 are substantially the same, and display uniformity is ensured.

In an exemplary implementation mode, in one repetition unit, a power supply connection line 34 and second active layers 32 in four sub-pixels may be of an interconnected integral structure.

In an exemplary implementation mode, a shape of the third active layer 33 may be a strip extending along the second direction Y, a first region of the third active layer 33 is connected with the compensation connection line 35, and a second region of the third active layer 33 is connected with the first electrode plate 11 through the third via V3, thereby achieving that a compensation signal is written into a first electrode of the third transistor T3 by the compensation signal line 23, and achieving a second electrode of the third transistor T3 has a same potential as the first electrode plate 11.

In an exemplary implementation mode, the compensation signal line 23 may be located between the second pixel column and the third pixel column, and the compensation signal line 23 may simultaneously provide compensation signals to pixel drive circuits in four sub-pixels through the compensation connection line 35, so that four pixel drive circuits in one repetition unit may share one compensation signal line 23. That is, the compensation signal line 23 in one repetition unit has a one-drag-four structure. In the display substrate of the present disclosure, a compensation signal line is designed to have a one-drag-four structure, which saves a quantity of signal lines, reduces occupied space, has a simple structure and a reasonable layout, makes full use of layout space, improves a space utilization rate, and is beneficial to improving a resolution.

In an exemplary implementation mode, the compensation connection line 35 may be mirror-symmetric with respect to the compensation signal line 23, and this symmetrical structure according to the present disclosure may ensure that Resistor-Capacitor (RC) delays of compensation signals written into third transistors T3 in four sub-pixels are substantially the same, thus ensuring display uniformity.

In an exemplary implementation mode, in one repetition unit, a compensation connection line 35 and third active layers 33 in four sub-pixels may be of an interconnected integral structure.

In an exemplary implementation mode, a position of each pattern in the semiconductor layer within the repetition unit may be substantially mirror-symmetric with respect to the vertical reference line.

In an exemplary implementation mode, a position of each pattern of the semiconductor layer in the first sub-pixel P1 and the second sub-pixel P2 may be substantially mirror-symmetric with respect to a pixel reference line, a position of each pattern of the semiconductor layer in the third sub-pixel P3 and the fourth sub-pixel P4 may be substantially mirror-symmetric with respect to the pixel reference line, a position of each pattern of the semiconductor layer in the first sub-pixel P1 and the fourth sub-pixel P4 may be substantially mirror-symmetric with respect to the pixel reference line, a position of each pattern of the semiconductor layer in the second sub-pixel P2 and the third sub-pixel P3 may be substantially mirror-symmetric with respect to the pixel reference line, and the pixel reference line may be a straight line located between adjacent sub-pixels and extending along the second direction Y.

In an exemplary implementation mode, the semiconductor layer may be made of a metal oxide, such as an oxide containing indium and tin, an oxide containing tungsten and indium, an oxide containing tungsten, indium, and zinc, an oxide containing titanium and indium, an oxide containing titanium, indium, and tin, an oxide containing indium and zinc, an oxide containing silicon, indium, and tin, an oxide containing indium, gallium, and zinc, and the like. The semiconductor layer may be a single layer, a double-layer, or a multi-layer.

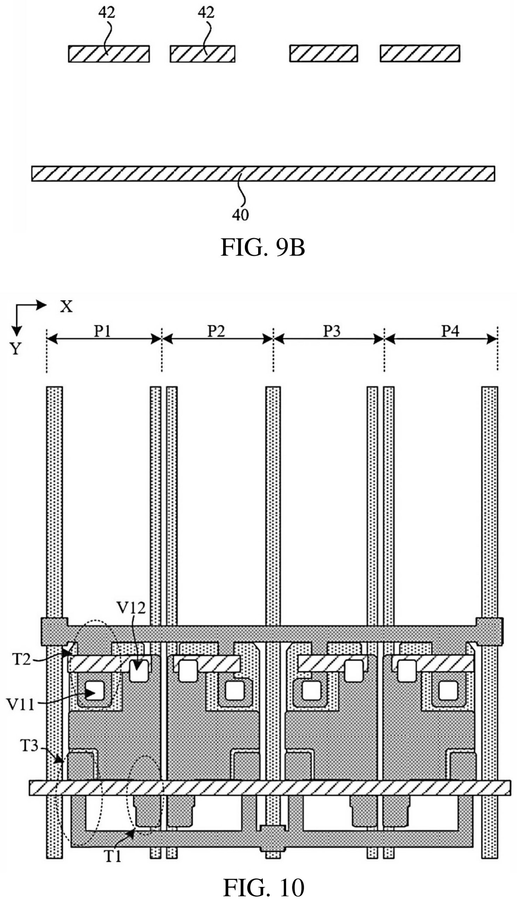

(14) A pattern of a second conductive layer is formed. In an exemplary implementation mode, forming the pattern of the second conductive layer may include: sequentially depositing a second insulation thin film and a second conductive thin film on the base substrate on which the aforementioned patterns are formed, patterning the second insulation thin film and the second conductive thin film through a patterning process to form a second insulation layer covering the semiconductor layer, and form the pattern of the second conductive layer disposed on the second insulation layer, as shown in FIGs. 9A and 9B, wherein FIG. 9B is a schematic plan view of the second conductive layer in FIG. 9A. In an exemplary implementation mode, the second conductive layer may be referred to as a Gate metal (GT) layer.

In an exemplary implementation mode, a pattern of a second conductive layer of each sub-pixel in the repetition unit may at least include a scan signal line 40 and a second gate electrode 42.

In an exemplary implementation mode, a shape of the scan signal line 40 may be a straight line or a polyline of which a main body portion extends along the first direction X, the scan signal line 40 may be located at one side of the second electrode plate 12 in the second direction Y, and the scan signal line 40 is configured to simultaneously control ON or OFF of all first transistors T1 and all third transistors T3 in four sub-pixels of the repetition unit.

In an exemplary implementation mode, an orthographic projection of the scan signal line 40 on the base substrate is at least partially overlapped with an orthographic projection of a first active layer in each sub-pixel on the base substrate, and the scan signal line 40 in an overlapping region may serve as a gate electrode of a first transistor T1.

In an exemplary implementation mode, the orthographic projection of the scan signal line 40 on the base substrate is at least partially overlapped with an orthographic projection of a third active layer in each sub-pixel on the base substrate, and the scan signal line 40 in an overlapping region may serve as a gate electrode of a third transistor T3.

In an exemplary implementation mode, in one sub-pixel, one scan signal line 40 may simultaneously serve as a first gate electrode and a third gate electrode, so that the scan signal line 40 may control ON or OFF of a first transistor T1 and a third transistor T3 in one sub-pixel.

In an exemplary implementation mode, in one repetition unit, one scan signal line 40 simultaneously serves as four first gate electrodes and four third transistors in four sub-pixels, so that the scan signal line 40 may control ON or OFF of four first transistors T1 and four third transistors T3 in one repetition unit.

In an exemplary implementation mode, in one pixel row, one scan signal line 40 simultaneously serves as all first gate electrodes and all third transistors in a plurality of sub-pixels, so that the scan signal line 40 may control ON or OFF of all first transistors T1 and all third transistors T3 in one pixel row.

In an exemplary implementation mode, a shape of the second gate electrode 42 may be a strip of which a main body portion extends along the first direction X, and the second gate electrode 42 may serve as a gate electrode of a second transistor T2. On one hand, an orthographic projection of the second gate electrode 42 on the base substrate is at least partially overlapped with an orthographic projection of the second active layer on the base substrate, on the other hand, the orthographic projection of the second gate electrode 42 on the base substrate is at least partially overlapped with the orthographic projection of the second electrode plate 12 on the base substrate.

In an exemplary implementation mode, a position of each pattern in the second conductive layer within the repetition unit may be substantially mirror-symmetric with respect to a vertical reference line.

In an exemplary implementation mode, a position of each pattern of the second conductive layer in the first sub-pixel P1 and the second sub-pixel P2 may be substantially mirror-symmetric with respect to a pixel reference line, a position of each pattern of the second conductive layer in the third sub-pixel P3 and the fourth sub-pixel P4 may be substantially mirror-symmetric with respect to the pixel reference line, a position of each pattern of the second conductive layer in the first sub-pixel P1 and the fourth sub-pixel P4 may be substantially mirror-symmetric with respect to the pixel reference line, and a position of each pattern of the second conductive layer in the second sub-pixel P2 and the third sub-pixel P3 may be substantially mirror-symmetric with respect to the pixel reference line.

In an exemplary implementation mode, after the second insulation thin film and the second conductive thin film are patterned, the pattern of the second insulation layer and the pattern of the second conductive layer are substantially the same, and the second insulation layer is disposed at a side of the second conductive layer close to the base substrate.

In an exemplary implementation mode, this process further includes a conductorization treatment. The conductorization treatment is to perform a plasma treatment by using the second conductive layer as a shield after the pattern of the second conductive layer is formed. The semiconductor layer shielded by the second conductive layer is used as a channel region of a transistor, and the semiconductor layer not shielded by the second conductive layer is processed into a conductive layer to form a conductive second electrode plate and a conductive source-drain region.

(15) Patterns of a third insulation layer and a planarization layer are formed. In an exemplary implementation mode, forming the patterns of the third insulation layer and the planarization layer may include: first depositing a third insulation thin film on the base substrate on which the aforementioned patterns are formed, then coating a planarization thin film, and patterning the planarization thin film and the third insulation thin film through a patterning process to form the third insulation layer that covers the second conductive layer, and the pattern of the planarization layer disposed on the third insulation layer, wherein the planarization layer is provided with a plurality of vias, as shown in FIG. 10.

In an exemplary implementation mode, a plurality of vias in each sub-pixel in the repetition unit at least include an eleventh via V11 and a twelfth via V12.

In an exemplary implementation mode, an orthographic projection of the eleventh via V11 on the base substrate is within a range of an orthographic projection of a second region of a second active layer on the base substrate. The planarization layer and the third insulation layer within the eleventh via V11 are etched away to expose a surface of the second region of the second active layer, and the eleventh via V11 is configured such that a second connection electrode formed subsequently is connected with the second region of the second active layer through this via. In an exemplary implementation mode, the eleventh via V11 may serve as an active via of the present disclosure.

In an exemplary implementation mode, in at least one sub-pixel, an orthographic projection of the eleventh via V11 on the base substrate is at least partially overlapped with an orthographic projection of the second via V2 on the base substrate.

In an exemplary implementation mode, an area of the orthographic projection of the eleventh via V11 on the base substrate may be larger than an area of the orthographic projection of the second via V2 on the base substrate, which may improve connection reliability.

In an exemplary implementation mode, the twelfth via V12 may include two sub-holes, an orthographic projection of one sub-hole on the base substrate is at least partially overlapped with an orthographic projection of the second gate electrode 42 on the base substrate, exposing a surface of the second gate electrode 42. An orthographic projection of the other sub-hole on the base substrate is at least partially overlapped with an orthographic projection of the second electrode plate 12 on the base substrate, exposing a surface of the second electrode plate 12. The twelfth via V12 is configured such that a first connection electrode formed subsequently is connected with the second gate electrode 42 and the second electrode plate 12 simultaneously through this via.

In some possible implementation modes, the twelfth via V12 may be a via of a transfer structure, and includes two half-holes, wherein one half-hole exposes the surface of the second gate electrode 42, and the other half-hole exposes the surface of the second electrode plate 12, so that the twelfth via V12 of the transfer structure, which is constituted by the two half-holes, exposes the second gate electrode 42 and the second electrode plate 12, simultaneously.

In an exemplary implementation mode, in this process, a one-time patterning process may be adopted to simultaneously form vias on the third insulation layer and the planarization layer, and the third insulation layer and the planarization layer share a one-time halftone or gray tone MASK plate (MASK) process, which effectively reduces times of patterning processes.

In an exemplary implementation mode, a plurality of vias on the third insulation layer within the repetition unit may be substantially mirror-symmetric with respect to the vertical reference line.

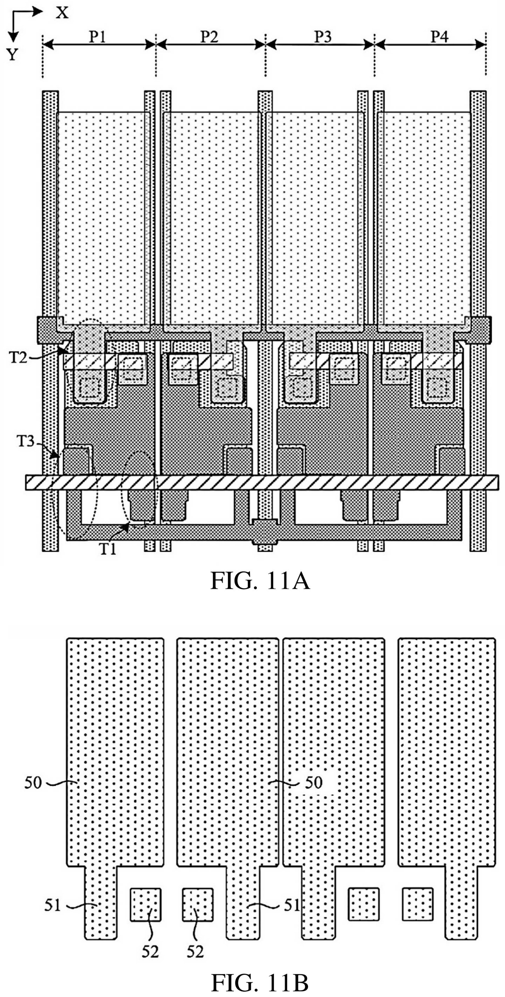

(16) A pattern of a third conductive layer is formed. In an exemplary implementation mode, forming the third conductive layer may include: depositing a third conductive thin film on the base substrate on which the aforementioned patterns are formed, patterning the third conductive thin film through a patterning process to form the third conductive layer disposed on the planarization layer, as shown in FIGs. 11A and 11B, and FIG. 11B is a schematic plan view of the third conductive layer in FIG. 11A.

In an exemplary implementation mode, a third conductive layer of each sub-pixel in the repetition unit may at least include a first connection electrode 51, a second connection electrode 52, and a first electrode 50.

In an exemplary implementation mode, a shape of the first connection electrode 51 may be a strip of which a main body portion extends along the second direction Y, a first end of the first connection electrode 51 is connected with the second region of the second active layer through the eleventh via V11, and a second end of the first connection electrode 51 is connected with the first electrode 50. In an exemplary implementation mode, the first connection electrode 51 may serve as an active connection electrode of the present disclosure.

In an exemplary implementation mode, a shape of the second connection electrode 52 may be a block (such as a rectangle). The second connection electrode 52 is simultaneously connected with the second gate electrode 42 and the second electrode plate 12 through the twelfth via V12. In an exemplary implementation mode, the second gate electrode 32 is connected with a second region of the first active layer, so the second connection electrode 52 achieves that a second electrode of the first transistor T1, a gate electrode of the second transistor T2, and the second electrode plate 12 of the storage capacitor have a same potential, forming a first node N1 in a pixel drive circuit. In an exemplary implementation mode, the second connection electrode 52 may serve as a gate connection electrode of the present disclosure.

In an exemplary implementation mode, a shape of the first electrode 50 may be a rectangle, corners of the rectangle may be provided with chamfers, grooves, or protrusions, and an edge of the first electrode 50 at a side close to the second electrode plate 12 is connected with the second end of the first connection electrode 51. Since the second region of the second active layer is connected with the first electrode plate 11 through a via, and the second region of the third active layer is connected with the first electrode plate 11 through a via, the first connection electrode 51 achieves that a second electrode of the second transistor T2, a second electrode of the third transistor T3, and the first electrode plate 11 of the storage capacitor have a same potential, forming a second node N2 in the pixel drive circuit.

In an exemplary implementation mode, the first electrode plate 11 has a potential of the second node N2 in the pixel drive circuit, the second electrode plate 12 has a potential of the first node N1 in the pixel drive circuit, and the first electrode plate 11 and the second electrode plate 12 constitute a storage capacitor of the pixel drive circuit.

In an exemplary implementation mode, the first connection electrode 51 and the first electrode 50 may be of an interconnected integral structure.

In an exemplary implementation mode, the first electrode 50 may be an anode of a light emitting device, or the first electrode 50 may be a cathode of the light emitting device.

In an exemplary implementation mode, at least one sub-pixel may include a circuit region and a light transmitting region. The first transistor T1, the second transistor T2, the third transistor T3, and the storage capacitor may be disposed in the circuit region, the first electrode 50 may be disposed in the light transmitting region, and an orthographic projection of the first electrode 50 on the base substrate is not overlapped with the orthographic projection of the second electrode plate 12 on the base substrate.

In an exemplary implementation mode, four first electrodes 50 in one repetition unit may be sequentially disposed along the first direction X, and may be connected with pixel drive circuits in the first sub-pixel P1, the second sub-pixel P2, the third sub-pixel P3, and the fourth sub-pixel P4, respectively. In some possible implementation modes, an arrangement mode of anodes may be adjusted as needs, which is not specifically limited in the present disclosure.

In an exemplary implementation mode, a material of the third conductive layer may be a transparent conductive material, such as Indium Tin Oxide (ITO) or Indium Zinc Oxide (IZO).

In an exemplary implementation mode, a position of each pattern in the third conductive layer within the repetition unit may be substantially mirror-symmetric with respect to a vertical reference line.

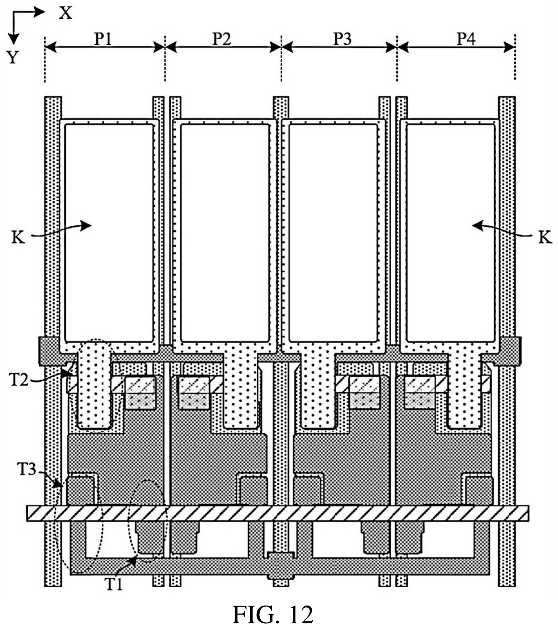

(17) A pixel definition layer is formed. In an exemplary implementation mode, forming a pattern of the pixel definition layer may include: coating a pixel definition thin film on the base substrate on which the aforementioned patterns are formed, and patterning the pixel definition thin film through a patterning process to form the pixel definition layer that covers the fourth conductive layer, as shown in FIG. 12.

In an exemplary implementation mode, a pixel opening K is disposed on the pixel definition layer of each sub-pixel in the repetition unit, the pixel definition thin film within the pixel opening K is removed to expose a surface of the first electrode 50, and an orthographic projection of the pixel opening K on the base substrate is located within a range of an orthographic projection of the first electrode 50 on the base substrate.

In an exemplary implementation mode, in a plane parallel to the base substrate, a shape of the pixel opening K may be similar to a shape of the first electrode 50, and in a plane perpendicular to the base substrate, a shape of a cross-section of the pixel opening K may be a rectangle, a trapezoid, or the like.

In an exemplary implementation mode, a shape of a pixel opening may include any one or more of following: a triangle, a rectangle, a trapezoid, a parallelogram, a five-frame shape, a six-frame shape, a circle, and an ellipse.

In an exemplary implementation mode, shapes of pixel openings of four sub-pixels may be the same or may be different. Areas of the pixel openings of the four sub-pixels may be the same or may be different.

In an exemplary implementation mode, shapes and areas of pixel openings of four sub-pixels may be different to adapt to transmittances of filters of different sub-pixels, so that light emitting devices of the four sub-pixels may emit light with same brightness at different currents, service lives of the light emitting devices of the four sub-pixels are optimized to a maximum extent, and a product life is guaranteed.

In an exemplary implementation mode, the pixel definition layer may be made of polyimide, acrylic, or polyethylene terephthalate, etc.

(18) Patterns of an organic emitting layer and a cathode are formed. In an exemplary implementation mode, forming the patterns of the organic emitting layer and the cathode may include: forming a pattern of an organic emitting layer, wherein the organic emitting layer is connected with the first electrode 50 through the pixel opening K. Subsequently, a second electrode is formed, and the second electrode is connected with the organic emitting layer.

In an exemplary implementation mode, the organic emitting layer may include an Emitting Layer (EML) and any one or more of following: a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation mode, the organic emitting layer may be formed through evaporation using a Fine Metal Mask (FMM) or an Open Mask, or formed by using an inkjet process.

(19) A pattern of an encapsulation structure layer is formed. In an exemplary implementation mode, forming the pattern of the encapsulation structure layer may include: depositing a first inorganic thin film using an open mask, so as to form a first encapsulation layer. Then, inkjet printing an organic material is performed on the first encapsulation layer by using an inkjet printing process, and a second encapsulation layer is formed after curing to form a film. Then, a second inorganic thin film is deposited by using an open mask to form a third encapsulation layer, wherein the first encapsulation layer, the second encapsulation layer, and the third encapsulation layer form the encapsulation structure layer. The first encapsulation layer and the third encapsulation layer may be made of any one or more of Silicon Oxide (SiOx), Silicon Nitride (SiNx), Silicon Carbide (SiC), Silicon Carbonitride (SiCN), and Silicon Oxynitride (SiON), and may be a single layer, a multi-layer, or a composite layer. The second encapsulation layer may be made of a resin material, forming a stacked structure of an inorganic material/an organic material/an inorganic material, wherein an organic material layer is disposed between two inorganic material layers, which may ensure that external water vapor cannot enter a light emitting structure layer.

So far, the drive circuit layer, the light emitting structure layer disposed on the drive circuit layer, and the encapsulation structure layer disposed on the light emitting structure layer have been prepared on the base substrate. In a plane perpendicular to the display substrate, the drive circuit layer may at least include a first conductive layer, a first insulation layer, a semiconductor layer, a second insulation layer, a second conductive layer, a third insulation layer, and a planarization layer that are sequentially stacked on the base substrate. The light emitting structure layer may at least include a first electrode, a pixel definition layer, an organic emitting layer, and a second electrode, and the encapsulation structure layer may include a first encapsulation layer, a second encapsulation layer, and a third encapsulation layer which are stacked.

In an exemplary implementation mode, the base substrate may be a flexible base substrate, or a rigid base substrate. The rigid base substrate may be made of, but is not limited to, one or more of glass and quartz. The flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. In an exemplary implementation mode, the flexible base substrate may include a first flexible material layer, a first inorganic material layer, a semiconductor layer, a second flexible material layer, and a second inorganic material layer which are stacked, wherein materials of the first flexible material layer and the second flexible material layer may be Polyimide (PI), Polyethylene Terephthalate (PET), or a surface-treated polymer soft film, or the like, materials of the first inorganic material layer and the second inorganic material layer may be Silicon Nitride (SiNx) or Silicon Oxide (SiOx), or the like, for improving a water and oxygen resistance capability of the base substrate, and a material of the semiconductor layer may be amorphous silicon (a-si).

In an exemplary implementation mode, the first conductive layer and the second conductive layer may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure or a multi-layer composite structure, such as Mo/Cu/Mo. The third conductive layer may be made of a transparent conductive material, such as Indium Tin Oxide (ITO) or Indium Zinc Oxide (IZO). The first insulation layer, the second insulation layer, and the third insulation layer may be made of any one or more of Silicon Oxide (SiOx), Silicon Nitride (SiNx), and Silicon Oxynitride (SiON), and may be a single-layer, a multi-layer, or a composite layer. The planarization layer may be made of an organic material such as resin.

In an exemplary implementation mode, the display substrate according to the embodiment may include a color film structure layer, and the color film structure layer may be disposed between the third insulation layer and the planarization layer. In at least one repetition unit, the color film structure layer may include a plurality of color film units. At least one color film unit may include a color filter layer, and the color filter layer is configured to enable a corresponding sub-pixel to emit light of a desired color. In an exemplary implementation mode, a preparation process of the display substrate may include: first depositing the third insulation layer on the base substrate on which the aforementioned patterns are formed, then coating a first color film layer on the third insulation layer, and patterning the first color film layer using a patterning process to form a first color film unit. Subsequently, a second color film layer is coated, and the second color film layer is patterned using a patterning process to form a second color film unit. Then, a third color film layer is coated, and the third color film layer is patterned using a patterning process to form a third color film unit. Then, a planarization thin film is coated, and an eleventh via and a twelfth via are formed using a patterning process, and the planarization layer, the color film structure layer, and the third insulation layer within the vias are removed.

At present, existing display substrates have problems of complex production processes and high production costs, etc. For example, a preparation process of a drive circuit layer in a display substrate requires seven-times patterning (MASK) processes, which not only has a relatively low production efficiency and a relatively high production cost, but also affects a product yield adversely.

A display substrate with a bottom emission structure is provided in an embodiment of the present disclosure. By disposing structures such as a first power supply line, a data signal line, and a compensation signal line in a first conductive layer, a first active layer, a second active layer, and a third active layer located in a semiconductor layer are respectively connected with the first power supply line, the data signal line, and the compensation signal line through vias, thereby not only reducing a quantity of conductive layers, but also reducing a patterning process of a transfer via and a patterning process of a transfer conductive layer, so that a preparation process of a drive circuit layer only needs five-times patterning processes, thereby reducing a quantity of patterning processes, effectively improving a production efficiency, effectively reducing a production cost, and maximizing a product yield.

In a display substrate, in order to reduce a quantity of patterning processes, a gate metal layer and a semiconductor layer are connected by using a transfer via structure including a deep half-hole and a shallow half-hole, and it is necessary to perform a conductorization treatment on the semiconductor layer twice, which not only leads to a damage to the semiconductor layer, but also complicates a process and reduces a process yield. In the display substrate according to the present disclosure a transfer via structure does not need to be adopted and a semiconductor layer does not need to be conducted twice, thereby not only reducing a damage of etching to the semiconductor layer, but also reducing a quantity of vias, reducing sizes of vias, reducing process complexity, and improving a process yield.

In the display substrate according to the present disclosure, by disposing the power supply connection line on the semiconductor layer, the power supply connection line and the first power supply lines form a mesh structure for transmitting a first power supply signal in a mesh shape, which may not only effectively reduce a resistance of a first power supply line and reduce a voltage drop of the first power supply signal, but also effectively improve uniformity of the first power supply signal in the display substrate, effectively improve display uniformity, and improve display quality.

The display substrate according to the present disclosure is of a 3T1C one gate structure. A pixel drive circuit is driven by using one scan signal line, and one scan signal line is connected with a first transistor and a third transistor in the pixel drive circuit. By reducing a quantity of scan signal lines, a structure of the pixel drive circuit may be simplified, an occupied area of the pixel drive circuit may be reduced, which is beneficial to achieving high-resolution display. Moreover, a light transmitting area of a light transmitting region may be effectively increased, and a space proportion of the light transmitting region may be increased, which is beneficial to achievement of high-transparency display. In addition, since one repetition unit only needs to be driven by one scan signal line, quantities of corresponding gate drive circuits (Gate Driver on Arrays (GOAs)) and clock signal lines (CLKs) may be reduced by a plurality of times, areas occupied by the gate drive circuits and clock signal lines are effectively reduced, which is beneficial to achieving a narrow bezel, and improving product advantages.

The preparation process in the present disclosure may be compatible well with an existing preparation process, is simple in process implementation, is easy to implement, and has a high production efficiency, a low production cost, and a high yield.

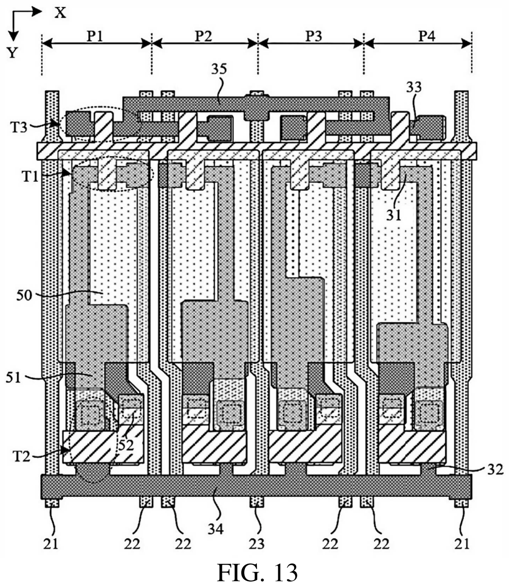

FIG. 13 is a schematic diagram of a structure of another display substrate according to an exemplary embodiment of the present disclosure, illustrating a structure of a pixel drive circuit in a repetition unit (four sub-pixels) in a bottom emission display substrate. As shown in FIG. 13, a main body structure of the display substrate according to this embodiment is substantially the same as that shown in FIG. 5, but a difference is that a storage capacitor of the display substrate according to this embodiment is a transparent storage capacitor.

In an exemplary implementation mode, the display substrate according to this embodiment may further include a transparent conductive layer disposed between the base substrate and the first conductive layer, a first electrode plate of the storage capacitor may be disposed in the transparent conductive layer, and a second electrode plate may be disposed in the semiconductor layer.

In an exemplary implementation mode, the transparent conductive layer may further include a transparent connection electrode, and the transparent connection electrode and the first electrode plate may be of an interconnected integral structure.

In an exemplary implementation mode, the second region of the second active layer is connected with the transparent connection electrode through a via.

In an exemplary implementation mode, a preparation process of the display substrate in this exemplary implementation mode may include following operations.

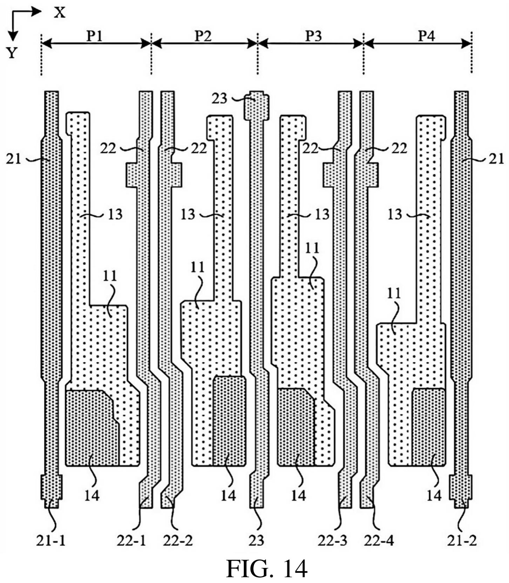

(21) Patterns of a transparent conductive layer and a first conductive layer are formed. In an exemplary implementation mode, forming the patterns of the transparent conductive layer and the first conductive layer may include: sequentially depositing a first conductive thin film and a second conductive thin film on a base substrate, patterning the first conductive thin film and the second conductive thin film through a patterning process to form the patterns of the transparent conductive layer and the first conductive layer on the base substrate, as shown in FIG. 14. In an exemplary implementation mode, the transparent conductive layer may be referred to as a first transparent (1ITO) layer, and the first conductive layer may be referred to as a Shield metal (SHL) layer.

In an exemplary implementation mode, a pattern of a transparent conductive layer in each sub-pixel in a repetition unit may at least include a first electrode plate 11 of a storage capacitor and a transparent connection electrode 13, and a first conductive layer of each sub-pixel in the repetition unit may at least include a shielding electrode 14.

In an exemplary implementation mode, a shape of the first electrode plate 11 may be a rectangle, and corners of the rectangle may be provided with chamfers. An edge of the rectangle may be a polyline, the first electrode plate 11 may be disposed in a middle region of the sub-pixel in the second direction Y, the first electrode plate 11 may be used as one transparent electrode plate of a transparent storage capacitor, and the first electrode plate 11 is configured to form the transparent storage capacitor with a second electrode plate formed subsequently.

In an exemplary implementation mode, a shape of the transparent connection electrode 13 may be a strip of which a main body portion extends along a second direction Y, may be disposed at a side of the first electrode plate 11 in an opposite direction of the second direction Y. A first end of the transparent connection electrode 13 is connected with the first electrode plate 11, a second end of the transparent connection electrode 13 extends towards a direction away from the first electrode plate 11, and the second end of the transparent connection electrode 13 is configured to be connected with a second region of a third active layer formed subsequently.

In an exemplary implementation mode, a first electrode plate 11 and a transparent connection electrode 13 of each sub-pixel may be of an interconnected integral structure.

In an exemplary implementation mode, a shape of the shielding electrode 14 may be a strip of which a main body portion extends along the second direction Y, may be disposed at a side of the first electrode plate 11 in the opposite direction of the second direction Y. The shielding electrode 14 is lapped with an extension section of the first electrode plate 11. The shielding electrode 14 is configured to be connected with a second region of a second active layer formed subsequently on one hand, and on the other hand, the shielding electrode 14 is configured to shade light for a second transistor, reducing a light intensity irradiated on the second transistor, reducing a leakage current of the second transistor, and thus reducing an influence of illumination on characteristics of the second transistor.

In an exemplary implementation mode, the first conductive layer of the repetition unit may further include two first power supply lines 21, four data signal lines 22, and one compensation signal line 23, shapes and positions of the first power supply lines 21, the data signal lines 22, and the compensation signal line 23 are substantially the same as those in aforementioned embodiments.

In an exemplary implementation mode, patterning the first conductive thin film and the second conductive thin film through the patterning process may include: after sequentially depositing the first conductive thin film and the second conductive thin film, coating a layer of photoresist on the second conductive thin film, and exposing the photoresist using a half-tone mask, after development, the photoresist forms a fully exposed region, a partially exposed region, and an unexposed region, wherein the photoresist in the fully exposed region is removed and a surface of the second conductive thin film is exposed in the fully exposed region, the photoresist in the partially exposed region is partially removed and the photoresist in the partially exposed region has a first thickness, the photoresist in the unexposed region is not changed and has a second thickness, and the first thickness is smaller than the second thickness. The unexposed region is a region where the shielding electrode 14, the first power supply lines 21, the data signal lines 22, and the compensation signal line 23 are located, and the partially exposed region is a region of the first electrode plate 11 and the transparent connection electrode 13. Subsequently, the first conductive thin film and the second conductive thin film in the fully exposed region are etched off through a first etching process to form patterns of the first power supply lines 21, the data signal lines 22, and the compensation signal line 23. Subsequently, the photoresist in the partially exposed region is removed using an ashing process, so that the partially exposed region exposes a surface of the second conductive thin film, and the unexposed region is still covered with photoresist. Subsequently, the second conductive thin film in the partially exposed region is etched off through a second etching process to expose the first conductive thin film and form patterns of the first electrode plate 11, the transparent connection electrode 13, and the shielding plate 14. Finally, remaining photoresist is stripped.

In an exemplary implementation mode, each of the shielding electrode 14, the first power supply lines 21, the data signal lines 22, and the compensation signal line 23 is of a double-layer structure of the first conductive thin film and the second conductive thin film, wherein a first transparent layer is disposed between the shield metal layer and the base substrate, and the first transparent layer and the first electrode plate 11 are of an interconnected integral structure, thus achieving an electrical connection between the shielding electrode 14 and the first electrode plate 11.

In an exemplary implementation mode, the first power supply lines 21, the data signal lines 22, and the compensation signal line 23 with the double-layer structure may effectively reduce a resistance of a signal line, reduce a voltage drop of a signal, and improve display performance.

In an exemplary implementation mode, a material of the transparent conductive layer may be a transparent conductive material, such as Indium Tin Oxide (ITO) or Indium Zinc Oxide (IZO).

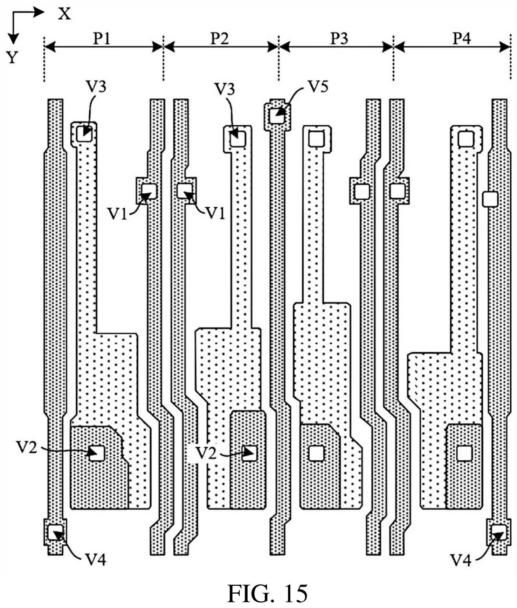

(22) A pattern of a first insulation layer is formed. In an exemplary implementation mode, forming the pattern of the first insulation layer may include: depositing a first insulation thin film on the base substrate on which the aforementioned patterns are formed, patterning the first insulation thin film through a patterning process to form the pattern of the first insulation layer that covers the transparent conductive layer and the first conductive layer, wherein a plurality of vias are disposed on the first insulation layer, as shown in FIG. 15.

In an exemplary implementation mode, a plurality of vias of each sub-pixel in the repetition unit at least include a first via V1, a second via V2, and a third via V3.

In an exemplary implementation mode, an orthographic projection of the first via V1 on the base substrate is at least partially overlapped with an orthographic projection of a data signal line 22 on the base substrate, the first insulation layer within the first via V1 is etched away to expose a surface of the data signal line 22, and the first via V1 is configured such that a first region of a first active layer formed subsequently is connected with the data signal line 22 through the via.

In an exemplary implementation mode, an orthographic projection of the second via V2 on the base substrate is at least partially overlapped with an orthographic projection of the shielding electrode 14 on the base substrate, the first insulation layer within the second via V2 is etched away, exposing a surface of the shielding electrode 14, and the second via V2 is configured such that a second region of a second active layer subsequently formed is connected with the first electrode plate 11 through the via.

In an exemplary implementation mode, an orthographic projection of the third via V3 on the base substrate is at least partially overlapped with an orthographic projection of a second end of the transparent connection electrode 13 on the base substrate, the first insulation layer within the third via V3 is etched away to expose a surface of the second end of the transparent connection electrode 13, and the third via V3 is configured such that a second region of a third active layer formed subsequently is connected with the second end of the transparent connection electrode 13 through the via.

In an exemplary implementation mode, the first insulation layer in the repetition unit may further include a fourth via V4 and a fifth via V5.

In an exemplary implementation mode, an orthographic projection of the fourth via V4 on the base substrate is at least partially overlapped with an orthographic projection of a first power supply line 21 on the base substrate. The first insulation layer within the fourth via V4 is etched away to expose a surface of the first power supply line 21, and the fourth via V4 is configured such that a power supply connection line formed subsequently is connected with the first power supply line 21 through the via. In an exemplary implementation mode, the fourth via V4 may be disposed in a first sub-pixel P1 and a fourth sub-pixel P4, respectively.

In an exemplary implementation mode, an orthographic projection of the fifth via V5 on the base substrate is at least partially overlapped with an orthographic projection of the compensation signal line 23 on the base substrate, the first insulation layer within the fifth via V5 is etched away to expose a surface of the compensation signal line 23, and the fifth via V5 is configured such that a compensation connection line formed subsequently is connected with the compensation signal line 23 through the via. In an exemplary implementation mode, the fifth via V5 may be disposed between a second sub-pixel P2 and a third sub-pixel P3.

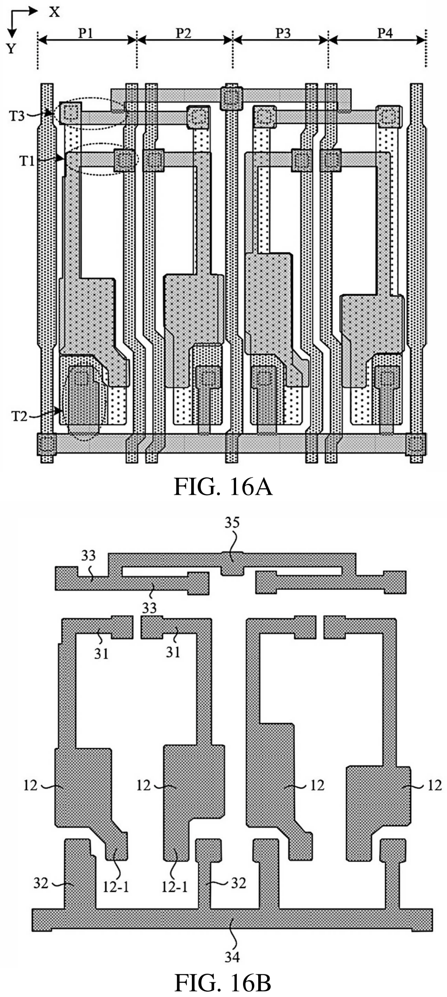

(23) A pattern of a semiconductor layer is formed. In an exemplary implementation mode, forming the pattern of the semiconductor layer may include: depositing a semiconductor thin film on the base substrate on which the aforementioned patterns are formed, and patterning the semiconductor thin film through a patterning process to form the pattern of the semiconductor layer disposed on the first insulation layer, as shown in FIGs. 16A and 16B, wherein FIG. 16B is a schematic plan view of the semiconductor layer in FIG. 16A.

In an exemplary implementation mode, a pattern of a semiconductor layer in each sub-pixel in the repetition unit may at least include a first active layer 31, a second active layer 32, a third active layer 33, a power supply connection line 34, a compensation connection line 35, and a second electrode plate 12.

In an exemplary implementation mode, a shape of the second electrode plate 12 may be a rectangle, and an orthographic projection of the second electrode plate 12 on the base substrate is at least partially overlapped with an orthographic projection of the first electrode plate 11 on the base substrate. The second electrode plate 12 may be used as the other transparent electrode plate of the transparent storage capacitor, and the first electrode plate 11 and the second electrode plate 12 constitute the transparent storage capacitor of a pixel drive circuit.

In an exemplary implementation mode, in one repetition unit, overlapping areas of orthographic projections of second electrode plates 12 and first electrode plates 11 in sub-pixels on the base substrate may be substantially the same, so that a capacity of a storage capacitor in each sub-pixel is substantially the same.

In an exemplary implementation mode, an electrode plate connection block 12-1 may be disposed on the second electrode plate 12. A shape of the electrode plate connection block 12-1 may be a block (e.g., a rectangle) and may be disposed at a side of the second electrode plate 12 in the second direction Y. A first end of the electrode plate connection block 12-1 is connected with the second electrode plate 12, a second end of the electrode plate connection block 12-1 extends towards a direction away from the second electrode plate 12, and the second end of the electrode plate connection block 12-1 is configured to be connected with a twelfth connection electrode formed subsequently.

In an exemplary implementation mode, a shape of the power supply connection line 34 may be a straight line or a polyline of which a main body portion extends along a first direction X. The power supply connection line 34 may be disposed at a side of the second electrode plate 12 in the second direction Y, and the power supply connection line 34 is connected with a first power supply line 21 through the fourth via V4.

In an exemplary implementation mode, in one repetition unit, an orthographic projection of the power supply connection line 34 on the base substrate is at least partially overlapped with orthographic projections of four data signal line 22 on the base substrate, and the orthographic projection of the power supply connection line 34 on the base substrate is at least partially overlapped with an orthographic projection of the compensation signal line 23 on the base substrate.

In an exemplary implementation mode, the power supply connection line 34 may serve as a transverse connection line, each of two first power supply lines 21 in one repetition unit is connected with the power supply connection line 34, so that the power supply connection line 34 extending along the first direction X and the first power supply lines 21 extending along the second direction Y form a mesh structure for transmitting a first power supply signal in a mesh shape on the display substrate, which not only may effectively reduce a resistance of a first power supply line and reduce a voltage drop of the first power supply signal, but also may effectively improve uniformity of the first power supply signal in the display substrate, effectively improve display uniformity, and improve display quality.

In an exemplary implementation mode, a shape of the compensation connection line 35 may be a straight line or a polyline of which a main body portion extends along the first direction X. The compensation connection line 35 may be disposed at a side of the second electrode plate 12 in an opposite direction of the second direction Y, and the compensation connection line 35 is connected with the compensation signal line 23 through the fifth via V5.

In an exemplary implementation mode, in one repetition unit, an orthographic projection of the compensation connection line 35 on the base substrate is at least partially overlapped with orthographic projections of the four data signal lines 22 on the base substrate, and the orthographic projection of the compensation connection line 35 on the base substrate is not overlapped with an orthographic projection of a first power supply line 21 on the base substrate.

In an exemplary implementation mode, the first active layer 31 may serve as an active layer of a first transistor T1, the second active layer 32 may serve as an active layer of a second transistor T2, and the third active layer 33 may serve as an active layer of a third transistor T3. The first active layer 31 and the third active layer 33 may be disposed between the compensation connection line 35 and the second electrode plate 12, and the second active layer 33 may be disposed between the power supply connection line 34 and the second electrode plate 12.

In an exemplary implementation mode, each of the first active layer 31, the second active layer 32, and the third active layer 33 may include a channel region, and a first region and a second region located at two sides of the channel region.

In an exemplary implementation mode, a shape of the first active layer 31 may be a character "L", and may be disposed at a side of the second electrode plate 12 in the opposite direction of the second direction Y. A first region of the first active layer 31 is connected with a data signal line 22 through the first via V1, and a second region of the first active layer 31 is connected with the second electrode plate 12, thereby achieving a data signal is written into a first electrode of the first transistor T1 by the data signal line 22. In an exemplary implementation mode, a first region of a first active layer 31 in each sub-pixel may be connected with a data signal line 22 through the first via V1, thereby achieving data signals are written into first electrodes of four first transistors T1 in one repetition unit by four data signal lines 22.

In an exemplary implementation mode, in one sub-pixel, a first active layer 31 and a second electrode plate 12 may be of an interconnected integral structure.

In an exemplary implementation mode, a shape of the second active layer 32 may be a strip extending along the second direction Y, and an orthographic projection of the second active layer 32 on the base substrate is at least partially overlapped with an orthographic projection of the shielding electrode 14 on the base substrate. An orthographic projection of a channel region of the second active layer 32 on the base substrate may be located within a range of the orthographic projection of the shielding electrode 14 on the base substrate, and the shielding electrode 14 may shield the channel region of the second active layer 32 to avoid an influence of light on a channel and reduce a leakage current, thereby avoiding an influence of illumination on characteristics of a transistor, and ensuring electrical performance of the second transistor T2.

In an exemplary implementation mode, a first region of the second active layer 32 is connected with the power supply connection line 34, and a second region of the second active layer 32 is connected with the shielding electrode 14 through the second via V2. Since the power supply connection line 34 is connected with a first power supply line, it is achieved that a first power supply signal is written into the first electrode of the second transistor T2 by a first power supply line 21. Since the shielding electrode 14 is connected with the first electrode plate 11, a second electrode of the second transistor T2 has a same potential as the first electrode plate 11.

In an exemplary implementation mode, the two first power supply lines 21 may include a first first power supply line and a second first power supply line, wherein the first first power supply line may be located at a side of a first pixel column in an opposite direction of the first direction X, and the second first power supply line may be located at a side of a fourth pixel column in the first direction X. Since the first first power supply line of the first pixel column may simultaneously supply a first power supply signal to pixel drive circuits in the first sub-pixel P1 to the fourth sub-pixel P4 through the power supply connection line 34, and the second first power supply line of the fourth pixel column may simultaneously supply a first power supply signal to pixel drive circuits in the first sub-pixel P1 to the fourth sub-pixel P4 through the power supply connection line 34, a first power supply line 21 in one repetition unit has a two-drag-four structure. In the display substrate according to the present disclosure, a first power supply line is designed to have a two-drag-four structure, which saves a quantity of signal lines, reduces occupied space, has a simple structure and a reasonable layout, makes full use of layout space, improves a space utilization rate, and is beneficial to improving a resolution.

In an exemplary implementation mode, two first power supply lines 21 in one repetition unit are substantially mirror-symmetric with respect to a vertical reference line, and four second transistors T2 in one repetition unit are substantially mirror-symmetric with respect to the vertical reference line. This symmetrical structure according to the present disclosure may ensure that a voltage drop of a first power supply line written into the second transistors T2 is substantially the same, and display uniformity is ensured.

In an exemplary implementation mode, in one repetition unit, the power supply connection line 34 and second active layers 32 in four sub-pixels may be of an interconnected integral structure.

In an exemplary implementation mode, a shape of the third active layer 33 may be a strip extending along the first direction X, a first region of the third active layer 33 is connected with the compensation connection line 35, and a second region of the third active layer 33 is connected with a second end of the transparent connection electrode 13 through the third via V3, thereby achieving a compensation signal is written into a first electrode of the third transistor T3 by the compensation signal line 23. Since the transparent connection electrode 13 is connected with the first electrode plate 11, a second electrode of the third transistor T3 has a same potential as the first electrode plate 11.

In an exemplary implementation mode, the compensation signal line 23 may be located between a second pixel column and a third pixel column, and the compensation signal line 23 may simultaneously provide compensation signals to pixel drive circuits in the four sub-pixels through the compensation connection line 35, so that the four pixel drive circuits in one repetition unit may share one compensation signal line 23. That is, the compensation signal line 23 in one repetition unit has a one-drag-four structure. In the display substrate according to the present disclosure, a compensation signal line is designed to have a one-drag-four structure, which saves a quantity of signal lines, reduces occupied space, has a simple structure and a reasonable layout, makes full use of layout space, improves a space utilization rate, and is beneficial to improving a resolution.

In an exemplary implementation mode, the compensation connection line 35 may be mirror-symmetric with respect to the compensation signal line 23, and this symmetrical structure according to the present disclosure may ensure that RC delays of compensation signals written to third transistors T3 in the four sub-pixels are substantially the same, thus ensuring display uniformity.

In an exemplary implementation mode, in one repetition unit, the compensation connection line 35 and third active layers 33 in the four sub-pixels may be of an interconnected integral structure.

In an exemplary implementation mode, the semiconductor layer may be made of a metal oxide, such as an oxide containing indium and tin, an oxide containing tungsten and indium, an oxide containing tungsten, indium, and zinc, an oxide containing titanium and indium, an oxide containing titanium, indium, and tin, an oxide containing indium and zinc, an oxide containing silicon, indium, and tin, an oxide containing indium, gallium, and zinc, and the like. The semiconductor layer may be a single layer, a double-layer, or a multi-layer.

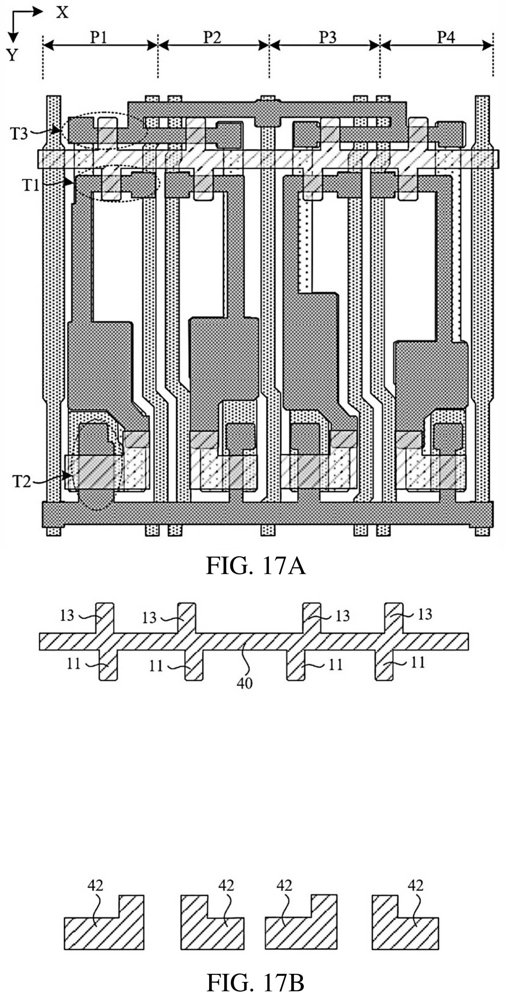

(24) A pattern of a first conductive layer is formed. In an exemplary implementation mode, forming the pattern of the first conductive layer may include: sequentially depositing a second insulation thin film and a second conductive thin film on the base substrate on which the aforementioned patterns are formed, patterning the second insulation thin film and the second conductive thin film through a patterning process to form a second insulation layer disposed on the semiconductor layer, and form the pattern of the first conductive layer disposed on the second insulation layer, as shown in FIGs. 17A and 17B, wherein FIG. 17B is a schematic plan view of the first conductive layer in FIG. 17A.

In an exemplary implementation mode, a pattern of a first conductive layer of each sub-pixel in the repetition unit may at least include a scan signal line 40, a first gate electrode 41, a second gate electrode 42, and a third gate electrode 43.

In an exemplary implementation mode, a shape of the scan signal line 40 may be a straight line or a polyline of which a main body portion extends along the first direction X, the scan signal line 40 may be located at a side of the second electrode plate 12 in the opposite direction of the second direction Y, and the scan signal line 40 is configured to simultaneously control ON or OFF of all first transistors T1 and all third transistors T3 in four sub-pixels of the repetition unit.

In an exemplary implementation mode, a shape of the first gate electrode 31 may be a strip extending along the second direction Y, and may be disposed at a side of the scan signal line 40 close to the first active layer 21. A first end of the first gate electrode 31 is connected with the scan signal line 40, a second end of the first gate electrode 31 extends towards a direction of the first active layer 21, and an orthographic projection of the first gate electrode 31 on the base substrate is at least partially overlapped with an orthographic projection of the first active layer 21 on the base substrate. In an exemplary implementation mode, the first gate electrode 31 may serve as a gate electrode of the first transistor T1, and may control ON or OFF of the first transistor T1.

In an exemplary implementation mode, the first gate electrode 31 and the scan signal line 40 may be of an interconnected integral structure.

In an exemplary implementation mode, a shape of the third gate electrode 33 may be a strip extending along the second direction Y, and may be disposed at a side of the scan signal line 40 close to the third active layer 23. A first end of the third gate electrode 33 is connected with the scan signal line 40, a second end of the third gate electrode 33 extends towards a direction of the third active layer 23, and an orthographic projection of the third gate electrode 33 on the base substrate is at least partially overlapped with an orthographic projection of the third active layer 23 on the base substrate. In an exemplary implementation mode, the third gate electrode 33 may serve as a gate electrode of the third transistor T3, and may control ON or OFF of the third transistor T3.

In an exemplary implementation mode, the third gate electrode 33 and the scan signal line 40 may be of an interconnected integral structure.

In an exemplary implementation mode, in one repetition unit, a scan signal line 40, first gate electrodes 31 and third gate electrodes 33 in four sub-pixels may be of an interconnected integral structure.

In an exemplary implementation mode, a first gate electrode 31 and a third gate electrode 33 in one sub-pixel are connected with a same scan signal line 40, and one scan signal line 40 may simultaneously control ON or OFF of the first transistor T1 and the third transistor T3.

In an exemplary implementation mode, first gate electrodes 31 and third gate electrodes 33 in four sub-pixels in one repetition unit are connected with a same scan signal line 40, and one scan signal line 40 simultaneously controls ON or OFF of four first transistors T1 and four third transistors T3 in one repetition unit.

In an exemplary implementation mode, first gate electrodes 31 and third gate transistors 33 in a plurality of sub-pixels in one pixel row are simultaneously connected with a same scan signal line 40, and one scan signal line 40 simultaneously controls ON or OFF of all first transistors T1 and all third transistors T3 in one pixel row.

In an exemplary implementation mode, a shape of the second gate electrode 42 may be a character "L", and the second gate electrode 42 may serve as a gate electrode of the second transistor T2. On one hand, an orthographic projection of the second gate electrode 42 on the base substrate is at least partially overlapped with an orthographic projection of the second active layer on the base substrate. On the other hand, the orthographic projection of the second gate electrode 42 on the base substrate is at least partially overlapped with an orthographic projection of an electrode plate connection block 12-1 of the second electrode plate 12 on the base substrate.

In an exemplary implementation mode, after the second insulation thin film and the second conductive thin film are patterned, a pattern of the second insulation layer and a pattern of the first conductive layer are substantially the same, and the second insulation layer is disposed at a side of the first conductive layer close to the base substrate.

In an exemplary implementation mode, this process further includes a conductorization treatment. The conductorization treatment is to perform a plasma treatment by using the first conductive layer as a shield after the pattern of the first conductive layer is formed. The semiconductor layer shielded by the first conductive layer is used as a channel region of a transistor, and the semiconductor layer not shielded by the first conductive layer is processed into a conductive layer to form a conductive second electrode plate and a conductive source-drain region.

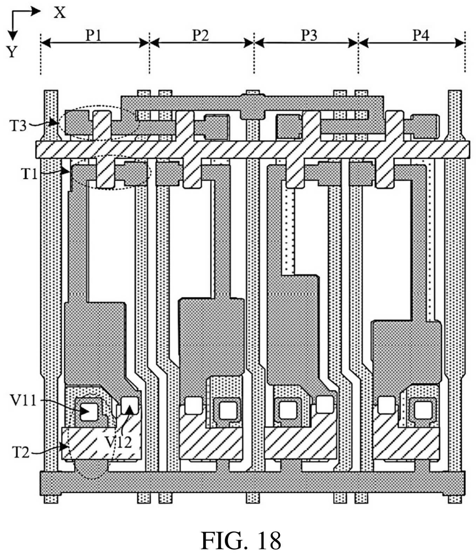

(25) Patterns of a third insulation layer and a planarization layer are formed. In an exemplary implementation mode, forming the patterns of the third insulation layer and the planarization layer may include: first depositing a third insulation thin film on the base substrate on which the aforementioned patterns are formed, then coating a planarization thin film, and patterning the planarization thin film and the third insulation thin film through a patterning process to form the third insulation layer that covers the first conductive layer and the pattern of the planarization layer disposed on the third insulation layer, and the planarization layer is provided with a plurality of vias, as shown in FIG. 18.

In an exemplary implementation mode, a plurality of vias in each sub-pixel in the repetition unit at least include an eleventh via V11 and a twelfth via V12.

In an exemplary implementation mode, an orthographic projection of the eleventh via V11 on the base substrate is within a range of an orthographic projection of the second region of the second active layer on the base substrate. The planarization layer and the third insulation layer within the eleventh via V11 are etched away to expose a surface of the second region of the second active layer, and the eleventh via V11 is configured such that a second connection electrode formed subsequently is connected with the second region of the second active layer through this via.

In an exemplary implementation mode, the twelfth via V12 may include two sub-holes, an orthographic projection of one sub-hole on the base substrate is at least partially overlapped with an orthographic projection of the second gate electrode 42 on the base substrate, exposing a surface of the second gate electrode 42. An orthographic projection of the other sub-hole on the base substrate is at least partially overlapped with an orthographic projection of the second electrode plate 12 on the base substrate, exposing a surface of the second electrode plate 12. The twelfth via V12 is configured such that a first connection electrode formed subsequently is connected with the second gate electrode 42 and the second electrode plate 12 simultaneously through this via.

In some possible implementation modes, the twelfth via V12 may be a via of a transfer structure, and includes two half-holes, wherein one half-hole exposes the surface of the second gate electrode 42, and the other half-hole exposes the surface of the second electrode plate 12, so that the twelfth via V12 of the transfer structure, which is constituted by the two half-holes, exposes the second gate electrode 42 and the second electrode plate 12, simultaneously.

In an exemplary implementation mode, in this process, a one-time patterning process may be adopted to simultaneously form vias on the third insulation layer and the planarization layer, and the third insulation layer and the planarization layer share a one-time halftone or gray tone MASK plate (MASK) process, which effectively reduces times of patterning processes.

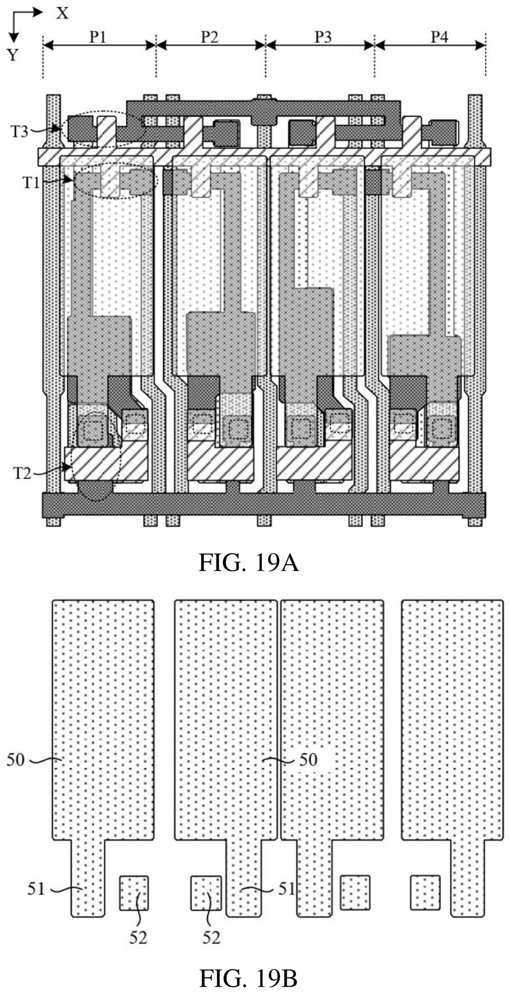

(26) A pattern of a third conductive layer is formed. In an exemplary implementation mode, forming the third conductive layer may include: depositing a third conductive thin film on the base substrate on which the aforementioned patterns are formed, patterning the third conductive thin film through a patterning process to form the third conductive layer disposed on the planarization layer, as shown in FIGs. 19A and 19B, and FIG. 19B is a schematic plan view of the third conductive layer in FIG. 19A. In an exemplary implementation mode, the third conductive layer may be referred to as a second transparent (2ITO) layer.

In an exemplary implementation mode, a third conductive layer of each sub-pixel in the repetition unit may at least include a first connection electrode 51, a second connection electrode 52, and a first electrode plate 50.

In an exemplary implementation mode, a shape of the first connection electrode 51 may be a strip of which a main body portion extends along the second direction Y, a first end of the first connection electrode 51 is connected with the second region of the second active layer through the eleventh via V11, and a second end of the first connection electrode 51 is connected with the first electrode 50.

In an exemplary implementation mode, a shape of the second connection electrode 52 may be a block (such as a rectangle). The second connection electrode 52 is simultaneously connected with the second gate electrode 42 and the electrode plate connection block 12-1 through the twelfth via V12. In an exemplary implementation mode, the electrode plate connection block 12-1 is connected with the second electrode plate 12, and the second electrode plate 12 is connected with a second region of the first active layer, so that the second connection electrode 52 achieves that a second electrode of the first transistor T1, a gate electrode of the second transistor T2, and the second electrode plate 12 of the storage capacitor to have a same potential, forming a first node N1 in a pixel drive circuit.

In an exemplary implementation mode, a shape of the first electrode 50 may be a rectangle, corners of the rectangle may be provided with chamfers, grooves, or protrusions, and a side of the first electrode 50 is connected with the second end of the first connection electrode 51. The second region of the second active layer is connected with the shielding electrode 14 through a via, the shielding electrode 14 is connected with the first electrode plate 11, the second region of the third active layer is connected with the transparent connection electrode 13 through a via, and the transparent connection electrode is connected with the first electrode plate 11, so the first connection electrode 51 achieves that a second electrode of the second transistor T2, a second electrode of the third transistor T3, and the first electrode plate 11 of the storage capacitor have a same potential, forming a second node N2 in the pixel drive circuit.

In an exemplary implementation mode, the first electrode plate 11 has a potential of the second node N2 in the pixel drive circuit, the second electrode plate 12 has a potential of the first node N1 in the pixel drive circuit, and the first electrode plate 11 and the second electrode plate 12 constitute the storage capacitor of the pixel drive circuit.

In an exemplary implementation mode, the first connection electrode 51 and the first electrode 50 may be of an interconnected integral structure.

In an exemplary implementation mode, the first electrode 50 may be an anode of a light emitting device, or the first electrode 50 may be a cathode of the light emitting device.

In an exemplary implementation mode, the first electrode 50 may also serve as an auxiliary capacitor of the storage capacitor. Since the first electrode 50 is connected with the first connection electrode 51, the first connection electrode 51 has the potential of the second node N2 in the pixel drive circuit, so that the first electrode 50 with the potential of the second node N2 and the second electrode plate 12 with the potential of the first node N1 form the auxiliary capacitor, and the auxiliary capacitor and the storage capacitor are connected in parallel. In the present disclosure, the auxiliary capacitor is formed using the first electrode, and the auxiliary capacitor and the storage capacitor are connected in parallel, so that on one hand, a capacitance value of the storage capacitor may be effectively increased, on the other hand, an electrode plate area may be reduced under a condition of ensuring the capacitance value of the storage capacitor, and an occupied area may be effectively reduced.

In an exemplary implementation mode, four first electrodes 50 in one repetition unit may be sequentially disposed along the first direction X, and may be connected with pixel drive circuits in the first sub-pixel P1, the second sub-pixel P2, the third sub-pixel P3, and the fourth sub-pixel P4, respectively. In some possible implementation modes, an arrangement mode of anodes may be adjusted as needs, which is not specifically limited in the present disclosure.

In an exemplary implementation mode, a material of the third conductive layer may be a transparent conductive material, such as Indium Tin Oxide (ITO) or Indium Zinc Oxide (IZO).

(27) Patterns of a pixel definition layer, an organic emitting layer, a cathode, and an encapsulation structure layer are formed, and a preparation process is substantially the same as that in the aforementioned embodiment, which will not be repeated here.

So far, a drive circuit layer, a light emitting structure layer disposed on the drive circuit layer, and an encapsulation structure layer disposed on the light emitting structure layer have been prepared on the base substrate. In a plane perpendicular to the display substrate, the drive circuit layer may at least include a transparent conductive layer, a first conductive layer, a first insulation layer, a semiconductor layer, a second insulation layer, a second conductive layer, a third insulation layer, and a planarization layer that are sequentially stacked on the base substrate. The light emitting structure layer may at least include a first electrode, a pixel definition layer, an organic emitting layer, and a second electrode, and the encapsulation structure layer may include a first encapsulation layer, a second encapsulation layer, and a third encapsulation layer which are stacked.

In an exemplary implementation mode, the display substrate according to this embodiment may include a color film structure layer, and the color film structure layer may be disposed between the third insulation layer and the planarization layer, which will not be repeated here.

According to the display substrate in the embodiments of the present disclosure, not only a technical effect of the display substrate shown in FIG. 5 may be achieved, but also the transparent storage capacitor is composed of the transparent conductive layer and a transparent semiconductor layer, so that light may be emitted through the transparent storage capacitor, the storage capacitor may be disposed in a pixel opening, which not only may effectively increase a capacitance amount of the storage capacitor, but also may effectively increase a pixel aperture ratio.

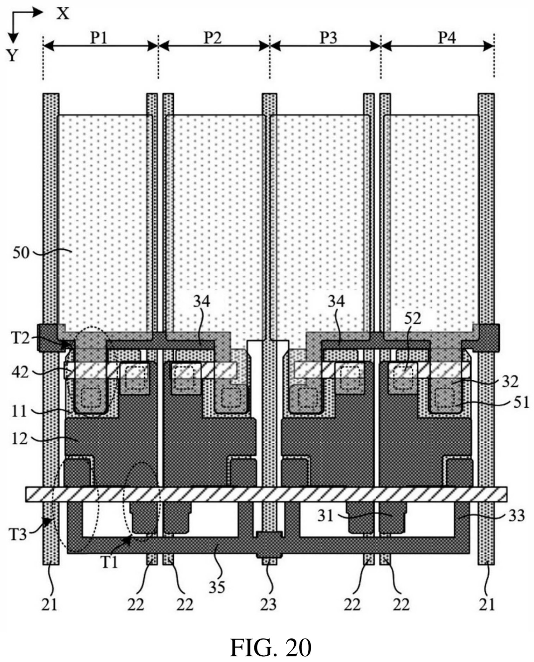

FIG. 20 is a schematic diagram of a structure of yet another display substrate according to an exemplary embodiment of the present disclosure, illustrating a structure of a pixel drive circuit in a repetition unit (four sub-pixels) in a bottom emission display substrate. A main body structure of the display substrate in this embodiment is substantially the same as that shown in FIG. 5, but a difference is that a non-mesh structure is adopted for a first power supply line structure of the display substrate in this embodiment, and two first power supply lines 21 adjacent in the first direction X are connected with different power supply connection lines 34.

Structures of a first electrode plate 11, a second electrode plate 12, first power supply lines 21, data signal lines 22, a compensation signal line 23, a compensation connection line 35, a first transistor T1, a second transistor T2, a third transistor T3, and a first anode 60 of the display substrate in this embodiment are substantially the same as those shown in FIG. 5, which will not be repeated here.

As shown in FIG. 20, a shape of each of two power supply connection lines 34 in this embodiment may be a straight line or a polyline of which a main body portion extends along a first direction X. The first power supply connection line 34 may be disposed in a first pixel column and a second pixel column, one end of the first power supply connection line 34 is connected with a first first power supply line 21 through a fourth via V4, and the other end of the first power supply connection line 34 is connected with first regions of second active layers 32 in the first pixel column and the second pixel column, respectively. The second power supply connection lines 34 may be disposed in a third pixel column and a fourth pixel column, one end of the second power supply connection line 34 is connected with a second first power supply line 21 through the fourth via V4, and the other end of the second power supply connection line 34 is connected with first regions of second active layers 32 in the third pixel column and the fourth pixel column, respectively.

In an exemplary implementation mode, in one repetition unit, an orthographic projection of a power supply connection line 34 on the base substrate is at least partially overlapped with orthographic projections of four data signal line 22 on the base substrate, and the orthographic projection of the power supply connection line 34 on the base substrate is not overlapped with an orthographic projection of the compensation signal line 23 on the base substrate.

In an exemplary implementation mode, the first first power supply line of the first pixel column may simultaneously supply a first power supply signal to pixel drive circuits in a first sub-pixel P1 and a second sub-pixel P2 through a power supply connection line 34, and the second first power supply line of the fourth pixel column may simultaneously supply a first power supply signal to pixel drive circuits in a third sub-pixel P3 and a fourth sub-pixel P4 through a power supply connection line 34, a first power supply line 21 in one repetition unit has a one-drag-two structure. In the display substrate according to the present disclosure, a first power supply line is designed to have a one-drag-two structure, which saves a quantity of signal lines, reduces occupied space, has a simple structure and a reasonable layout, makes full use of layout space, improves a space utilization rate, and is beneficial to improving a resolution.

The display substrate according to the embodiment of the present disclosure may not only achieve a technical effect of the display substrate shown in FIG. 5, but also effectively increase a pixel aperture ratio by using a first power supply line structure with a non-mesh structure, improve a display effect, and is more suitable for display of a display type.

A structure shown in the present disclosure and a preparation process thereof are merely exemplary description. In an exemplary implementation mode, a corresponding structure may be changed and patterning processes may be added or reduced according to actual needs, which is not limited here in the present disclosure.

In an exemplary implementation mode, the display substrate according to the present disclosure may be applied to a display apparatus with a pixel drive circuit, such as an OLED, quantum dot display (QLED), light emitting diode display (Micro LED or Mini LED), or Quantum Dot Light Emitting Diode display (QDLED), which is not limited here in the present disclosure.

An exemplary implementation mode of the present disclosure also provides a preparation method of a display substrate, for preparing the display substrate of the aforementioned embodiments. In an exemplary implementation mode, the display substrate includes a plurality of repetition units, wherein at least one repetition unit includes a plurality of sub-pixels, at least one sub-pixel includes a pixel drive circuit and a data signal line connected with the pixel drive circuit, the pixel drive circuit at least includes a storage capacitor and a first transistor, the storage capacitor at least includes a first electrode plate and a second electrode plate, an orthographic projection of the first electrode plate on a display substrate plane is at least partially overlapped with an orthographic projection of the second electrode plate on the display substrate plane; the preparation method may include: forming a first conductive layer on a base substrate, wherein the first conductive layer at least includes the data signal line; and forming a semiconductor layer on the first conductive layer, wherein the semiconductor layer includes at least the second electrode plate and a first active layer of the first transistor; in at least one sub-pixel, the first active layer is connected with the data signal line through a via.

The present disclosure also provides a display apparatus which includes the display substrate of the aforementioned embodiments. The display apparatus may be any product or component with a display function, such as a mobile phone, a tablet computer, a television, a display, a laptop computer, a digital photo frame, and a navigator.

Although implementation modes disclosed in the present disclosure are as above, it should be noted that the above implementation modes are exemplary only rather than restrictive. Therefore, the present disclosure is not limited to what is specifically shown and described here. Various modifications, substitutions, or omissions may be made in forms and details of implementation without departing from the scope of the present disclosure.

## Claims

1. A display substrate, comprising a plurality of repetition units, wherein at least one repetition unit comprises a plurality of sub-pixels, and at least one sub-pixel comprises a pixel drive circuit and a data signal line connected with the pixel drive circuit, the pixel drive circuit at least comprises a storage capacitor and a first transistor, and the storage capacitor at least comprises a first electrode plate and a second electrode plate, and an orthographic projection of the first electrode plate on a display substrate plane is at least partially overlapped with an orthographic projection of the second electrode plate on the display substrate plane; in a direction perpendicular to the display substrate, the display substrate comprises a first conductive layer disposed on a base substrate and a semiconductor layer disposed at a side of the first conductive layer away from the base substrate; the first conductive layer at least comprises the data signal line, and the semiconductor layer at least comprises the second electrode plate and a first active layer of the first transistor; in at least one sub-pixel, the first active layer is connected with the data signal line through a via.

2. The display substrate according to claim 1, wherein in at least one sub-pixel, the first active layer and the second electrode plate are of an interconnected integral structure.

3. The display substrate according to claim 1, wherein the pixel drive circuit further comprises a second transistor, and the second transistor is connected with a first power supply line through a power supply connection line; the first conductive layer further comprises the first power supply line, and the semiconductor layer further comprises the power supply connection line and a second active layer of the second transistor; in at least one sub-pixel, the second active layer is connected with the power supply connection line, and the power supply connection line is connected with the first power supply line through a via.

4. The display substrate according to claim 3, wherein in at least one sub-pixel, the second active layer and the power supply connection line are of an interconnected integral structure.

5. The display substrate according to claim 3, wherein a shape of the first power supply line is a straight line or a polyline extending along a second direction, and a shape of the power supply connection line is a straight line or a polyline extending along a first direction, and the first direction intersects with the second direction; two first power supply lines adjacent in the first direction are connected with a same power supply connection line to form a mesh structure.

6. The display substrate according to claim 3, wherein a shape of the first power supply line is a straight line or a polyline extending along a second direction, and a shape of the power supply connection line is a straight line or a polyline extending along a first direction, and the first direction intersects with the second direction; two first power supply lines adjacent in the first direction are connected with different power supply connection lines.

7. The display substrate according to claim 3, wherein the display substrate further comprises a second conductive layer disposed at a side of the semiconductor layer away from the base substrate, the second conductive layer at least comprises a second gate electrode of the second transistor, and the second gate electrode is connected with the second electrode plate through a gate connection electrode.

8. The display substrate according to claim 7, wherein the display substrate further comprises a third conductive layer disposed at a side of the second conductive layer away from the base substrate, the third conductive layer comprises, at least, the gate connection electrode; the gate connection electrode is respectively connected with the second gate electrode and the second electrode plate through a same via, or the gate connection electrode is connected with the second gate electrode through one via and connected with the second electrode plate through another via.

9. The display substrate according to claim 8, wherein the third conductive layer further comprises a first electrode and an active connection electrode, the first electrode and the active connection electrode are of an interconnected integral structure, and the active connection electrode is connected with the second active layer through an active via.

10. The display substrate according to claim 9, wherein the second active layer is connected with the first electrode plate through a plate-level via, or the second active layer is connected with a transparent connection electrode through a plate-level via, and the transparent connection electrode and the first electrode plate are of an interconnected integral structure.

11. The display substrate according to claim 10, wherein in at least one sub-pixel, an orthographic projection of the active via on the base substrate is at least partially overlapped with an orthographic projection of the plate-level via on the base substrate.

12. The display substrate according to claim 1, wherein the pixel drive circuit further comprises a third transistor, the third transistor at least comprises a third active layer, the first conductive layer further comprises a compensation signal line, and the compensation signal line is connected with third active layers of the plurality of sub-pixels in the repetition unit through the semiconductor layer.

13. The display substrate according to claim 12, wherein the semiconductor layer further comprises a compensation connection line, the compensation signal line is connected with the compensation connection line through a via, and the compensation connection line is connected with the third active layers of the plurality of sub-pixels in the repetition unit.

14. The display substrate according to claim 13, wherein in at least one repetition unit, the compensation connection line and the third active layers of the plurality of sub-pixels are of an interconnected integral structure.

15. The display substrate according to claim 12, wherein in at least one repetition unit, a shape of the compensation signal line is a straight line or a polyline extending along a second direction, and the compensation signal line is disposed at an intermediate position of the repetition unit in a first direction, and the first direction intersects with the second direction.

16. The display substrate according to claim 15, wherein in at least one repetition unit, a plurality of sub-pixels at least comprise a red sub-pixel, a white sub-pixel, a green sub-pixel, and a blue sub-pixel sequentially disposed along the first direction, the red sub-pixel comprises a red data signal line, the green sub-pixel comprises a green data signal line, the blue sub-pixel comprises a blue data signal line, the red data signal line is disposed at one side of the compensation signal line in the first direction, and the green data signal line and the blue data signal line are disposed at the other side of the compensation signal line in the first direction.

17. The display substrate according to claim 16, wherein in at least one repetition unit, a first gap is disposed between a pixel drive circuit of the red sub-pixel and a pixel drive circuit of the white sub-pixel, a second gap is disposed between a pixel drive circuit of the green sub-pixel and a pixel drive circuit of the blue sub-pixel, the red data signal line is disposed in the first gap, and the green data signal line and the blue data signal line are disposed in the second gap.

18. The display substrate according to any one of claims 1 to 17, wherein the first electrode plate is disposed in the first conductive layer.

19. The display substrate according to any one of claims 1 to 17, wherein the display substrate further comprises a transparent conductive layer disposed between the base substrate and the first conductive layer, and the first electrode plate is disposed in the transparent conductive layer.

20. A display apparatus, comprising a display substrate according to any one of claims 1 to 19.

21. A preparation method of a display substrate, wherein the display substrate comprises a plurality of repetition units, at least one repetition unit comprises a plurality of sub-pixels, at least one sub-pixel comprises a pixel drive circuit and a data signal line connected with the pixel drive circuit, the pixel drive circuit at least comprises a storage capacitor and a first transistor, the storage capacitor at least comprises a first electrode plate and a second electrode plate, an orthographic projection of the first electrode plate on a display substrate plane is at least partially overlapped with an orthographic projection of the second electrode plate on the display substrate plane; the preparation method comprises:
forming a first conductive layer on a base substrate, wherein the first conductive layer at least comprises the data signal line; and
forming a semiconductor layer on the first conductive layer, wherein the semiconductor layer comprises at least the second electrode plate and a first active layer of the first transistor; in at least one sub-pixel, the first active layer is connected with the data signal line through a via.
